(19) Europäisches Patentamt
European Patent Office
Office européen des brevets

(11) **EP 0 985 952 A1**

(12) **EUROPEAN PATENT APPLICATION**
published in accordance with Art. 158(3) EPC

(43) Date of publication:
**15.03.2000 Bulletin 2000/11**

(51) Int. Cl.⁷: **G02F 1/1335**, G02B 27/02,
G02B 27/18, H01L 33/00,
H01S 3/18, H05B 33/00

(21) Application number: **99909298.4**

(22) Date of filing: **23.03.1999**

(86) International application number:
**PCT/JP99/01439**

(87) International publication number:
**WO 99/49358 (30.09.1999 Gazette 1999/39)**

(84) Designated Contracting States:
**DE FR GB**

(30) Priority: **26.03.1998 JP 7879998**

(71) Applicant:
**MITSUBISHI DENKI KABUSHIKI KAISHA
Tokyo 100-8310 (JP)**

(72) Inventors:
• **NAGAI, Haruhiko
Chiyoda-ku, Tokyo 100-8310 (JP)**

• **KAMIZAWA, Sadaomi
hiyoda-ku, Tokyo 100-8310 (JP)**
• **NISHINO, Ko
hiyoda-ku, Tokyo 100-8310 (JP)**

(74) Representative:
**Pfenning, Meinig & Partner
Mozartstrasse 17
80336 München (DE)**

(54) **IMAGE DISPLAY AND LIGHT-EMITTING DEVICE**

(57)    A liquid crystal projector is composed of a luminous device 50, a parallel-conversion optical system 60, an optical switch 70, and a display optical system 80, in order to obtain a simple optical system and a high light-utilization rate of the liquid crystal projector. The luminous device 50 applies LD arrays 51, 52 and 53 composed of semiconductor lasers 54 arrayed lengthwise and crosswise. Output beams from the semiconductor lasers 54 are converted into parallel beams through lens arrays 61, 62 and 63. Since the output beams from the semiconductor lasers 54 are linearly polarized beams of wave P or wave S, the polarization conversion optical system is unnecessary. By optionally combining the semiconductor lasers 54, it is possible to make the shape of the LD array 51, 52 or 53 be the same as the light-utilization shape of red-transmission type liquid crystal panel 71, green-transmission type liquid crystal panel 72, or blue-transmission type liquid crystal panel 73.

Fig.1

**Description**

TECHNICAL FIELD

The present invention relates to an image display apparatus, especially to the image display apparatus, such as a liquid crystal projector, applying a liquid crystal panel.

BACKGROUND ART

As a conventional image display apparatus, a polarization illumination apparatus is disclosed in Unexamined Japanese Patent Publication No. 8-304739. The conventional image display apparatus will now be explained with reference to the drawings and the statements described in the Unexamined Japanese Patent Publication No. 8-304739.

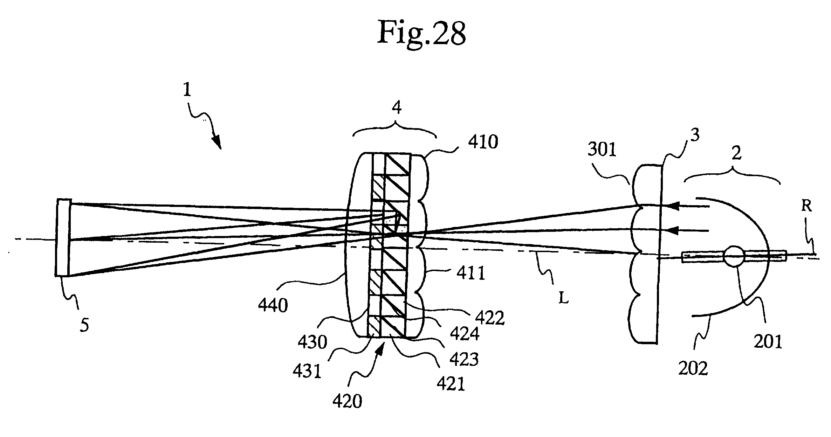

Fig. 28 shows a schematic plan view of summary configuration of the conventional polarization illumination apparatus. The polarization illumination apparatus 1 is mostly composed of a light source part 2, a first lens plate 3 and a second lens plate 4 which are arranged along the system optical axis L. Output beams from the light source part 2 are converged to the inside of the second lens plate 4 through the first lens plate 3. While the beams are passing through the second lens plate 4, random polarization beams are converted into polarization beams of one kind having the same polarization direction, to reach a luminous range 5.

The light source part 2 is mainly composed of a light source lamp 201 and a parabolic reflector 202. Random polarization beams emitted from the light source lamp 201 are reflected in one direction by the parabolic reflector 202 to be almost parallel luminous flux input into the first lens plate 3. It is acceptable to use an elliptical reflector or a spherical reflector and such instead of the parabolic reflector 202. The light source optical axis R is inclined by a specific angle with respect to the system optical axis L.

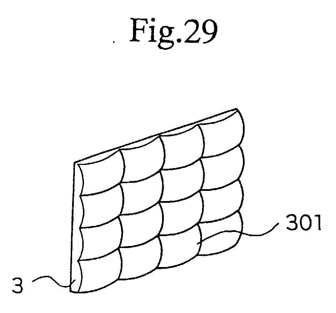

Fig. 29 shows an outward view of the first lens plate 3. As shown in Fig. 29, the first lens plate 3 is composed of plural micro rectangle collective lenses 301 arranged lengthwise and crosswise. Beams input to the first lens plate 3 form collective images, whose number is the same as the number of the rectangle collective lenses 301, on the plane perpendicular to the system optical axis L, by the collecting function of the rectangle collective lenses 301. These plural collective images will now be called as a secondary light source image because the plural collective images indicate just the projection image of the light source lamp.

With reference to Fig. 28 again, the second lens plate 4 is going to be explained. The second lens plate 4 is a compound layered composition of a collective lens array 410, a polarization separation prism array 420, a λ /2 phase-retardation plate 430 and an output side lens 440. The second lens plate 4 is located in the perpendicular plane to the system optical axis L, adjacent to the position of the secondary light source image formed by the first lens plate 3. The second lens plate 4 has functions of a second lens plate of integrator optical system, the polarization separation element, and a polarization-conversion element.

The collective lens array 410 has a configuration similar to the first lens plate 3. The collective lens array 410 is composed of arrayed plural collective lenses 411 whose number is the same as the number of the rectangle collective lenses 301 of the first lens plate 3. The collective lens array 410 has a function of converging beams from the first lens plate 3. The collective lens 410 corresponds to the second lens plate of the integrator optical system. It is not necessary for the collective lens 411 of the collective lens array 410 and the rectangle collective lens 301 of the first lens plate 3 to have the same size and shape, and the same lens characteristics. It is desirable for the collective lens array 410 and the rectangle collective lens 310 to be optimized depending upon the beam characteristics from the light source part 2. Anyhow, it is ideal for the principal ray of incident light into the polarization separation prism array 420 to be parallel to the system optical axis L. Considering this respect, most collective lenses 411 have the same lens characteristic as that of the rectangle collective lens 301 composing the first lens plate 3, or most collective lenses 411 having a similar shape to the rectangle collective lens 301 and the same lens characteristic as the rectangle collective lens 301 are used.

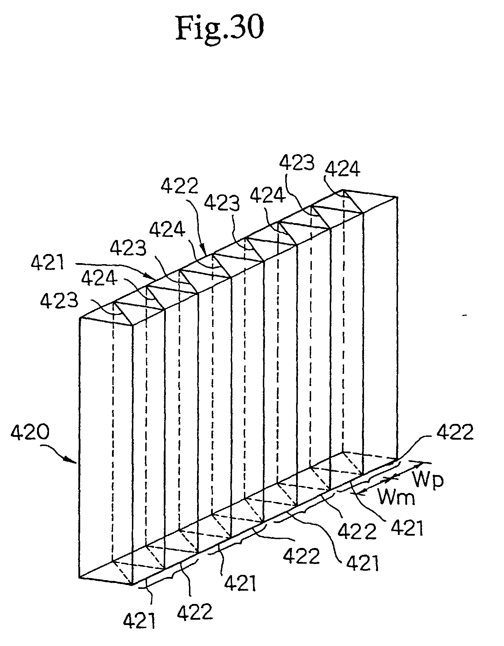

Fig. 30 shows an outward view of the polarization separation prism array 420. As shown in Fig. 30, the polarization separation prism 420 is composed of base units made by a pair of a polarization beam splitter 421 and a reflecting mirror 422. The polarization beam splitter 421 is composed of a quadrangular prism aggregation which includes a polarization separation film inside. The reflecting mirror 422 is also composed of a quadrangular prism aggregation which includes a reflection film inside. The polarization separation prism array 420 is composed of the pairs arranged in a plane, meaning the plane where the secondary light source image is formed. Each pair, the base unit is regularly arranged to be corresponding to each collective lens 411 of the collective lens array 410. The breath Wp of the polarization beam splitter 421 is equal to the breath Wm of the reflecting mirror 422. In the present case, the value of the breath Wp or Wm is specified to be a half of the breath of the collective lens 411 composing the collective lens array 410, but it is not restricted to be the half.

The second lens plate 4 including the polarization separation prism array 420 is positioned so that the secondary light source image formed by the first lens plate 3 can be located at the place of the polarization beam splitter 421. Therefore, the light source 2 is located so that the light source optical axis R of the light source 2 may slightly incline with respect to the system optical axis L.

Referring to Figs. 28 and 30, the random polarization beam will now be explained. The random polarization beam input into the polarization separation prism array 420 is separated into two polarization beams, a polarization beam P and a polarization beam S, having different polarization directions, by the polarization beam splitter 421. The polarization beam P passes through the polarization beam splitter 421 without changing its advancing direction. On the other hand, since the polarization beam S is reflected at a polarization separation film 423 of the polarization beam splitter 421, the advancing direction of the polarization beam S is changed by around 90 degrees. Then, the polarization beam S is reflected at a reflecting surface 424 of adjacent reflecting mirror 422 (the reflecting mirror for making a pair with the polarization beam splitter), the advancing direction of the polarization beam S is changed by around 90 degrees. Finally, the polarization beam S is output from the polarization separation prism array 420, being almost parallel to the polarization beam P.

The $\lambda$/2 phase-retardation plate 430, in which a $\lambda$/2 phase-retardation film 431 is regularly arranged, is provided on the outputting surface of the polarization separation prism array 420. Namely, the $\lambda$/2 phase-retardation film 431 is arranged only on the outputting surface of the polarization beam splitter 421 composing the polarization separation prism array 420, and the $\lambda$/2 phase-retardation film 431 is not arranged on the outputting surface of the reflecting mirror 422. Accordingly, when the polarization beam P output from the polarization beam splitter 421 passes through the $\lambda$/2 phase-retardation film 431, the polarization beam P receives the rotating function of the polarization surface, to be converted into the polarization beam S. On the other hand, since the polarization beam S output from the reflecting mirror 422 does not pass through the $\lambda$/2 phase-retardation film 431, the polarization beam S does not receive the rotating function of the polarization surface. The polarization beam S, not being changed, passes through the $\lambda$/2 phase-retardation plate 430.

To sum up the above, the random polarization beams are converted into the polarization beams of one kind (in this case, the polarization beam S), by the polarization separation prism array 420 and the $\lambda$/2 phase-retardation plate 430.

As set forth the above, the luminous flux having been converted into the polarization beams S is output from the output side lens 440 to go to the luminous range 5 and overlapped to be an image on the luminous range 5. Namely, the image sent from the first lens plate 3 is overlapped to be an image on the luminous range 5, through the second lens plate 4. Simultaneously, the random polarization beams are spatially separated into the polarization beams of two kinds having different polarization directions, by the polarization separation prism array 420. Then, the polarization beams of two kinds are converted into the polarization beams of one

kind through the $\lambda$/2 phase retardation plate 430. Namely, almost all the random beams are sent to the luminous range 5. Accordingly, the luminous range 5 is uniformly illuminated by the polarization beams of almost one kind.

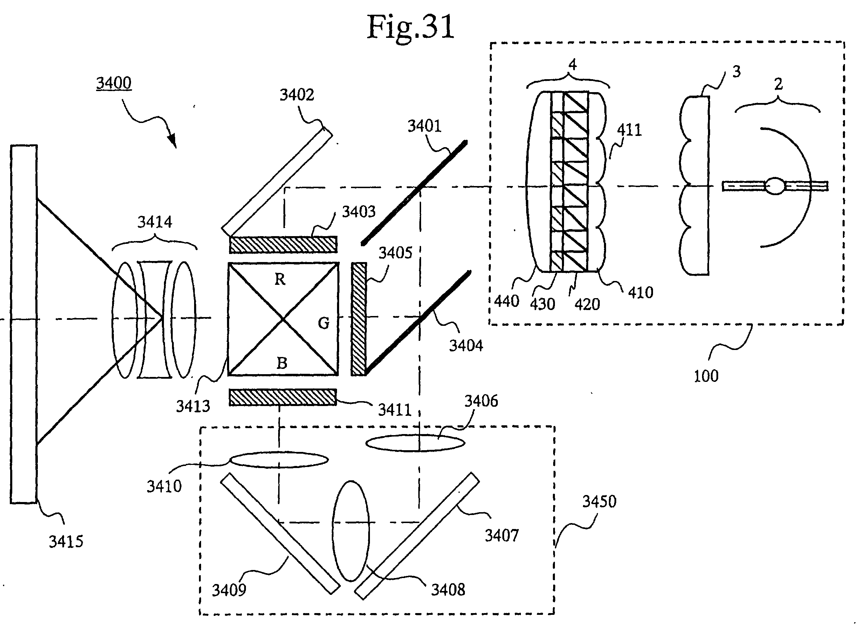

Fig. 31 shows an example of the projection type display apparatus applying the polarization illumination apparatus 1 of Fig. 28. The polarization Illumination apparatus 1 of a projection type display apparatus 3400 of Fig. 31 includes the light source part 2 for outputting random polarization beams in the one direction. The random polarization beams emitted from the light source part 2 are led to a specific position on the second lens plate 4, being converged by the first lens plate 3. Then, the random polarization beams are separated into the polarization beams of two kinds, by polarization separation prism array 420 in the second lens plate 4. The polarization beam P out of the separated polarization beams is converted into the polarization beam S by the $\lambda$/2 phase-retardation plate 430.

A red beam out of the luminous flux output from the polarization illumination apparatus 1 is transmitted through a blue and green reflecting dichroic mirror 3401, and a blue beam and a green beam are reflected at it. Then, the red beam is reflected at a reflecting mirror 3402, to go to a first liquid crystal light bulb 3403. The green beam out of the above blue beam and green beam is reflected at a green reflecting dichroic mirror 3404, to go to a second liquid crystal light bulb 3405.

Since the blue beam has the longest optical path of all the colors, light leading means 3450 composed of an input side lens 3406, a relay lens 3408, and an output side lens 3410 is provided for the blue beam. After passing through the green reflecting dichroic mirror 3404, the blue beam is led to the relay lens 3408 via the input side lens 3406 and a reflecting mirror 3407. After being converged on the relay lens 3408, the blue beam is led to the output side lens 3410 by a reflecting mirror 3409. Then, after all, the blue beam reaches a third liquid crystal light bulb 3411. The liquid crystal bulbs 3403, 3405, and 3411 respectively modulate each color. After image information corresponding to each color being applied, the modulated color is input to a dichroic prism 3413 (color combining means). On the dichroic prism 3413, a dielectric multi-layered film reflecting red and a dielectric multi-layered film reflecting blue are formed like a cross, and each modulated luminous flux is combined. The combined luminous flux passes through a projection lens 3414 (projection means) and forms an image on a screen 3415. What has been described above is the conventional apparatus disclosed in Unexamined Japanese Patent Publication No. 8-304739.

Now, the light source will be described. Being bright is important in the projection type liquid crystal projector. In order to realize the brightness, a bright light source is needed. Then, so as to obtain enough brightness from the light source, the size of the light source needs to be large. In order to obtain the enough brightness, according to the Laws of Stephen Boltzmann and Wien, it is impossible to make the light source size be less than a specific size. Besides, considering the life time of light source or the color temperature of light source, it is impossible to make the light source size be less than the specific size. When a long life time is required, it is inevitably necessary for the light source to have a specific length.

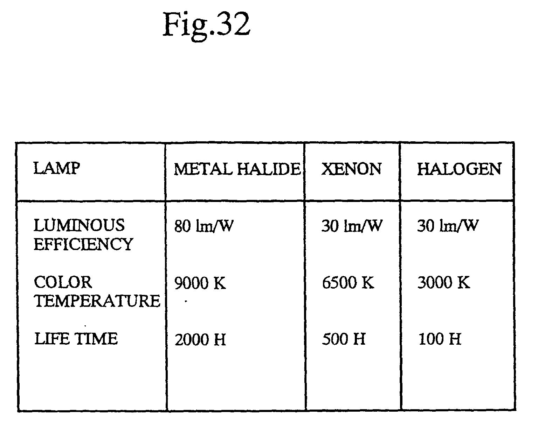

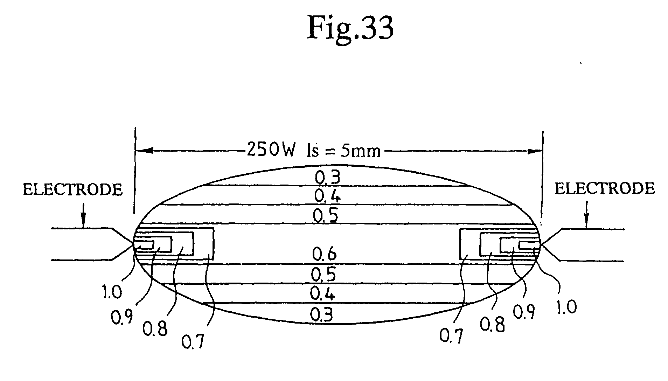

Fig. 32 shows characteristics of various light sources. In the case of the metal halide lamp having an appropriate color temperature, when a long time life of thousands of hours is required, the arc length, meaning the optical path length, based on the length (gap length) between the discharge electrodes is 5mm. Fig. 33 shows a space distribution of emission luminance of 250W whose arc length ls is 5mm. In Fig. 33, the brightest emission luminance is defined to be 1.0 and values less than or equal to 1.0 is a weighted value based on the 1.0.

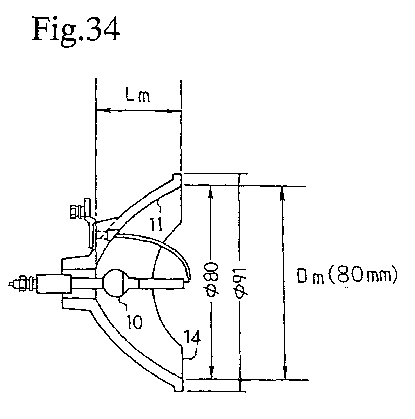

Fig. 34 shows a metal halide lamp of 250W used in the conventional liquid crystal projector. The metal halide lamp is composed of a lamp 10 and a main reflecting mirror 11. For instance, the main reflecting mirror 11 is composed of a rotating parabolic mirror. The main reflecting mirror 11 includes a filter 14 for cutting a band of beams, such as infrared rays outside of red, which causes unnecessary heat for the optical system. The infrared heats the main reflecting mirror and so on. In order to deal with (cool) the heat, the main reflecting mirror needs to be a specific size. The diameter Dm of main reflecting mirror of the lamp shown in Fig. 34 is 80mm (8cm). In the projection type liquid crystal projector, it is needed to make the beams be parallel illumination beams as much as possible. Beams emitted from the place at the focal point of the main reflecting mirror 11 composed of the rotating parabolic surface of Fig. 34 are parallel to the optical axis, while beams emitted from other place except the focal point are not parallel to the optical axis and incline to the optical axis. Supposing that the maximum value of the inclining is dθ (not shown), the inclination maximum value dθ is in proportion to the arc length ls located on the optical axis and in inverse proportion to the main reflecting mirror diameter Dm and the main reflecting mirror aspect ratio asr.

The aspect ratio asr is expressed by a value of "main reflecting mirror diameter Dm/main reflecting mirror length Lm". In the conventional lamp, as shown in Fig. 34, since the front end of the main reflecting mirror is placed ahead of the light source position in order to enhance the light collecting efficiency, so that the aspect ratio is around 2. As long as the arc length ls has a specific length, it is necessary for the main reflecting mirror diameter Dm to be long to some extent, in order to make the inclination maximum value dθ be within the light incident permission range of the dichroic mirror or the thin film element, such as the polarization separation element. For instance, if the light incident permission range of the dichroic mirror or the thin film element, such as the polarization separation element, is supposed to be 6 degrees, in the case of the light source whose arc length is 5mm and the conventional main reflecting mirror whose aspect ratio is equal to or less than 2 being used, it is impossible to set the main reflecting mirror diameter to be equal to or less than 7.5cm (3 inches).

It is ideal to use a point light source whose arc length is as short as possible in order to obtain parallel beams. However, if the light source is set to largely output for the purpose of obtaining the high luminance, the arc length needs to be long, so that it is difficult to obtain parallel beams. In order to input lights into a liquid crystal panel whose diagonal length is 1.3 inches, the lamp arc length needs to be equal to or less than 4mm. If the arc length is more than this value, since the light-utilizing efficiency is decreased even when the light source high outputting is planned, a large liquid crystal panel is needed, which causes the high cost. When a metal halide lamp of 400W (arc length 4mm) is used for the liquid crystal panel of 1.3 inches, the projector luminance is equal to or less than 2000lm. Even when a metal halide lamp of 500W (arc length 5mm) is used, it does not exceed 2000lm since the arc length is 5mm. Besides, the life time of high output discharge lamp becomes short when the arc length is shortened. Accordingly, it has been very difficult to technically solve the above problems.

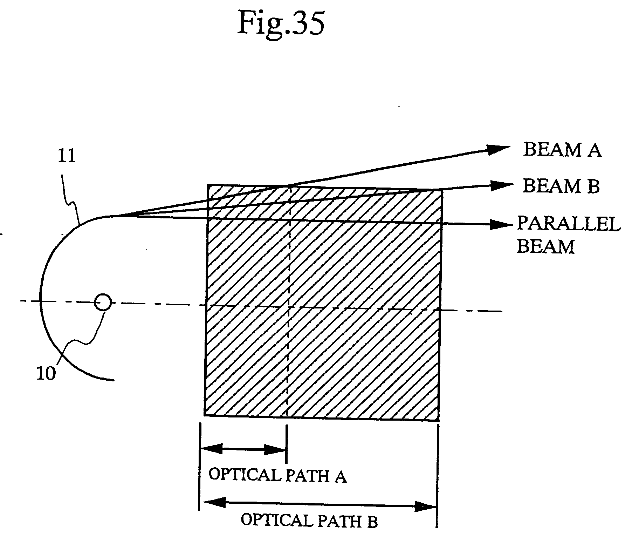

Fig. 35 illustrates a light shading. Parallel beams can be projected on the liquid crystal panel to be utilized regardless of the length, short or long, of the optical path. However, regarding a beam A and a beam B, whether they can be utilized or not is dependent on the optical path length. In the case of an optical path A whose optical path length is short, both the beams A and B can be utilized. In the case of an optical path B whose optical path length is long, only up to the beam B can be utilized but the beam A can not be utilized. Accordingly, it is necessary to make the optical path length be short as little as possible, in order to effectively utilize the light.

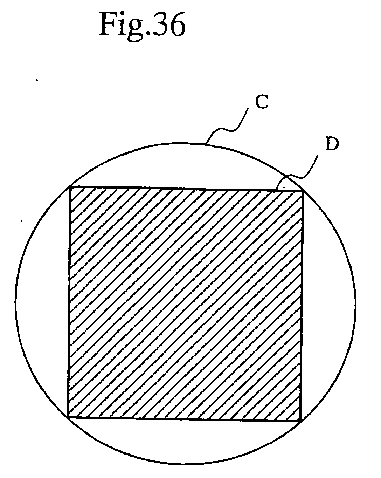

Fig. 36 illustrates the light-utilizing rate. C shows a section of the beam emitted from the main reflecting mirror 11. D indicates a beam part projected onto the liquid crystal panel, that is the part to be utilized, out of the beam emitted from the main reflecting mirror 11. Since the section of the beam from the main reflecting mirror 11 is circle and the liquid crystal panel is square, the circumferential beam can not be utilized. Consequently, beam being equal to or more than 30 percent out of the beam emitted from the main reflecting mirror 11 can not be utilized.

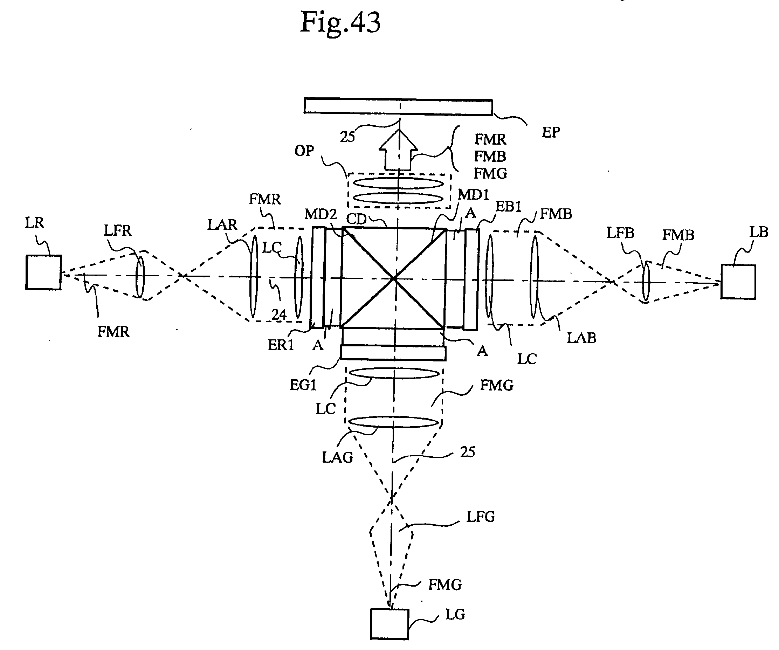

Fig. 43 shows a configuration of the conventional three color image projector, disclosed in Japanese Unexamined Patent Publication No. 6-511328 for PCT Application, respectively applying monochrome laser light sources LR, LG, and LB for each of the primary colors of red, green and blue. Referring to the description in the Publication, the configuration of Fig. 43 will now be explained.

The laser light source LR emits a polarization monochrome beam FMR corresponding to the primary color red. The red monochrome beam goes in the direction of a focal lens LFR along an axis 24. This operation brings about the convergence and divergence. Then, after going enough distance to make the red beam FMR be large for projecting the modulation screen, the red beam goes through an adaptive lens LAR to be parallel beams. The red beam goes to a visual field lens LC to form a red monochrome image. Further, for instance, the red beam goes to the liquid crystal matrix screen (LCD). After passing through an analyzer A, the red beam goes into a dichroic cube CD. This dichroic cube includes a dichroic mirror MD1 being sensitive to red. By this dichroic mirror MD1, the red beam is bent to be on a projection axis 25 being perpendicular to the propagation axis 24.

The laser light source LB emits a polarization monochrome beam FMB corresponding to the primary color blue. The blue monochrome beam FMB goes in the direction of the dichroic cube CD along the axis 24, meaning the blue monochrome beam goes in the opposite direction of the red beam FMR. Then, the blue beam FMB passes through a focal lens LFB, an adaptive lens LAB, the visual field lens LC, a modulation screen EB1 and the analyzer A in order. Namely, these operations of the blue beam FMB are the same as operations performed by a corresponding element for the red beam FMR. The blue beam FMB goes into the dichroic cube CD to reach a second dichroic mirror MD2 being sensitive to blue. By the conventional method, since the two dichroic mirrors compose planes being perpendicular each other, the blue beam FMB is reflected to be on the projection axis 25.

The laser light source LG emits a polarization monochrome beam FMG corresponding to the primary color green. The green monochrome beam FMG goes in the direction of the dichroic cube CD along the projection axis 25. Then, the green beam FMG passes through a focal lens LFG, an adaptive lens LAG, a modulation screen EG1 and the analyzer A in order. These operations are the same as operations performed by the corresponding elements for the beams FMR and FMB. The green beam FMG passes through the dichroic cube CD without reflecting, in the direction of a projection objective lens OP along the projection axis 25, with the red beam FMR and the blue beam FMB. The three beams FMR, FMB, and FMG respectively carrying a monochrome image are projected on a projection screen EP. As set forth above, the conventional apparatus disclosed in Japanese Unexamined Patent Publication No. 6-511328 for PCT Application has been explained.

Regarding the conventional image display apparatus, it is possible to enhance the light-utilizing rate because the polarization-conversion optical system is provided. However, it has a problem of the apparatus configuration being complicated. Besides, a problem of the luminous device being large-sized exists in the conventional image display apparatus. Since the arc length of the conventional luminous device is long, it is impossible to generate parallel beams because the luminous device can not be treated as a point light source. As the arc length is long, a part whose emission luminance is not uniform is generated, which causes a problem of generating unevenness or change in a displayed image. In the conventional image display apparatus, only a part of circle beams emitted from the luminous device is projected onto the liquid crystal panel, which causes a light-utilizing rate deterioration. Furthermore, since one laser light source is respectively used for red, green, and blue in the conventional image display apparatus applying the laser light source, it is difficult to generate an ample amount of light. Only a part of circle beams emitted from one laser light source is projected onto the liquid crystal panel, which causes a light-utilizing rate deterioration.

The present invention is contrived to solve the above problems. One of objects of the present invention is to provide an image display apparatus in which the polarization-conversion optical system is not necessary. Another object is to provide an image display apparatus which emits parallel beams and whose light-utilizing rate is enhanced. Another object is to provide an image display apparatus which is down-sized and whose image quality is enhanced. Another object is to provide a luminous element used in the above-stated image display apparatus.

DISCLOSURE OF THE INVENTION

An image display apparatus according to the present invention comprises:

(a) a luminous device composed of two-dimensionally arrayed plural semiconductor lasers;

(b) a parallel-conversion optical system for directly inputting beams output from the luminous device and converting the beams into substantially parallel beams;

(c) an optical switch for inputting beams output from the parallel-conversion optical system and modulating the beams; and

(d) a display optical system for inputting beams modulated by the optical switch in order to display an image,

wherein the image display apparatus further comprises a beam-conversion optical system between the parallel-conversion optical system and the optical switch, for converting a section size of the beams into a light-utilization size for the optical switch.

An image display apparatus according to the present invention comprises:

 (a) a luminous device composed of two-dimensionally arrayed plural semiconductor lasers;

 (b) a beam-conversion optical system for directly inputting beams output from the luminous device and converting at least one of a beam section shape and a beam section size of the beams;

 (c) an optical switch for inputting beams output from the beam-conversion optical system and modulating the beams; and

 (d) a display optical system for inputting beams modulated by the optical switch in order to display an image,

  wherein the image display apparatus further comprises a parallel-conversion optical system between the beam-conversion optical system and the optical switch, for inputting the beams output from the beam-conversion optical system and converting the beams into substantially parallel beams,

  wherein each of the two-dimensionally arrayed plural semiconductor lasers is one of a semiconductor laser outputting a multi-mode laser beam and a semiconductor laser outputting a laser beam of wide spectrum,

  wherein the luminous device includes arrayed integrated semiconductor lasers, and

  wherein the luminous device includes a surface-emitting semiconductor laser.

An image display apparatus according to the present invention comprises:

 (a) a luminous device composed of arrayed plural discharge lamps;

 (b) an optical switch for inputting beams output from the luminous device and modulating the beams;

 (c) a parallel-conversion optical system for inputting one of the beams output from the luminous device and beams modulated by the optical switch, and converting input beams into substantially parallel beams; and

 (d) a display optical system for inputting one of beams output from the parallel-conversion optical system and the beams modulated by the optical switch in order to display an image.

An image display apparatus according to the present invention comprises:

 (a) a luminous device composed of arrayed plural electro-luminescent elements;
 (b) an optical switch for inputting beams output from the luminous device and modulating the beams;
 (c) a parallel-conversion optical system for inputting one of the beams output from the luminous device and beams modulated by the optical switch, and converting input beams into substantially parallel beams; and
 (d) a display optical system for inputting one of beams output from the parallel-conversion optical system and the beams modulated by the optical switch in order to display an image,

  wherein the optical switch is a liquid crystal panel,

  wherein the optical switch is a reflection type liquid crystal panel,

  wherein the luminous device has plural light sources, an array shape of which is similar to a light-utilizing shape of the optical switch,

  wherein the image display apparatus further comprises a controller for controlling each of the plural light sources,

  wherein the luminous device is an aggregation of light sources having different spectral distributions,

  wherein the luminous device is an aggregation of discharge lamps, a gap length of each of which is less than 4mm, outputting parallel beam luminous flux of lumen equal to and more than several hundred, and the parallel-conversion optical system is an aggregation of reflectors making beams output from each of

the discharge lamps be parallel beams,
wherein the luminous device is able to change at least one of a beam section shape and a beam section size,
wherein the luminous device is able to change a light source type,
wherein the luminous device is able to change an array shape of light source,
wherein the luminous device allocates light sources having different sizes and

wherein the luminous device includes a lamp in which a part of a discharge tube is used as a reflector.

An image display apparatus according to the present invention comprises:

(a) a light source for emitting beams based on superradiation;

(b) an optical switch for inputting substantially linearly polarized beams output from the light source and modulating the substantially linearly polarized beams; and

(c) a display optical system for displaying beams modulated by the optical switch,

wherein the image display apparatus is a projection type image display apparatus and the light source is used for the projection type image display apparatus,

wherein the image display apparatus further comprises:

(a) a light source for color image;

(b) a light source for luminance image;

(c) an optical switch for color image for creating a color image by using the light source for color image;

(d) an optical switch for luminance image for creating a luminance image by using the light source for luminance image; and

(e) a combining optical system for combining the color image created by the optical switch for color image with the luminance image created by the optical switch for luminance image in order to create a combination image;
wherein the light source for emitting beams based on superradiation is used for at least one of the light source for color image and the light source for luminance image,

wherein the light source is used for a direct-view type image display apparatus,

wherein the light source includes an electroluminescent element, and

wherein the light source includes a light emitting diode element.

An image display apparatus according to the present invention comprises:

(a) a light source for emitting beams based on superradiation; and

(b) a display optical system for displaying beams modulated and output at the light source,

wherein the image display apparatus is a projection type image display apparatus and the light source is used for the projection type image display apparatus,
wherein the image display apparatus further comprises:

(a) a light source for color image;

(b) a light source for luminance image;

(c) an optical switch for color image for creating a color image by using the light source for color image;

(d) an optical switch for luminance image for creating a luminance image by using the light source for luminance image; and

(e) a combining optical system for combining the color image created by the optical switch for color image with the luminance image created by the optical switch for luminance image in order to create a combination image;
wherein the light source for emitting beams based on superradiation is used for at least one of the light source for color image and the light source for luminance image,

wherein the light source is used for a direct-view type image display apparatus,
wherein the light source includes an electroluminescent element, and
wherein the light source includes a light emitting diode element.

An image display apparatus according to the present invention comprises:

(a) a light source for color image;

(b) a light source for luminance image;

(c) an optical switch for color image for creating a color image by using the light source for color image;

(d) an optical switch for luminance image for creating a luminance image by using the light source for luminance image; and

(e) a combining optical system for combining the color image created by the optical switch for color image with the luminance image created by the optical switch for luminance image in order to create a combination image.

An image display apparatus according to the present invention comprises:

(a) a luminous device composed of arrayed light sources outputting different wavelength beams in time-sharing.

An image display apparatus according to the present invention comprises:

(a) a luminous device composed of arrayed light sources outputting different wavelength beams in time-sharing, and
(b) an optical switch for inputting the different wavelength beams output from each of the arrayed light sources of the luminous device, and modulating input different wavelength beams in time-sharing,

wherein the luminous device is composed of a plurality of luminous devices in which a plurality of semiconductor lasers outputting same wavelength beams is arrayed, and each of the plurality of luminous devices operates in time-sharing in order to output a beam in time-sharing,

wherein the luminous device is composed of arrayed semiconductor laser groups, each of which is made of semiconductor lasers of plural kinds outputting different wavelength beams,

wherein each of the semiconductor lasers of plural kinds operates in time-sharing in order to output a beam in time-sharing,

wherein the optical switch is a liquid crystal panel, and each of the arrayed semiconductor laser groups is provided to be corresponding to each pixel of the liquid crystal panel,

wherein the luminous device includes a surface-emitting semiconductor laser composed of arrayed semiconductor laser groups, each of which is made of semiconductor lasers of plural kinds outputting different wavelength beams,

wherein the image display apparatus further comprises a beam-conversion optical system for making a luminance distribution of beams output from the luminous device to be uniform,

wherein the beam-conversion optical system includes an analog phase control element for controlling a beam phase,

wherein the analog phase control element is a modified curve surface lens,

wherein the parallel-conversion optical system includes a lens array composed of arrayed plural lenses corresponding to the arrayed plural semiconductor lasers of the luminous device,

wherein each of the light sources is located at a position within a focal point of each of the arrayed plural lenses in order to make each of the arrayed plural lenses output beams diverging compared with parallel beams, so that circumference of each of the beams output from the each of the arrayed plural lenses can be overlapped each other,

wherein the parallel-conversion optical system includes a single lens for inputting the diverging beams, whose circumference is overlapped, output from the each of the arrayed plural lenses, and outputting parallel beams,

wherein at least either of the arrayed plural light sources and the arrayed plural lenses are installed to be movable in order to change a distance between the arrayed plural light sources and the arrayed plural lenses, so that a beam luminance distribution can be changed,

wherein the luminous device is an integrated luminous device composed of integrated plural light sources, and the parallel-conversion optical system includes a lens located in order to make a center part of the integrated luminous device be a focal point of the lens, and

wherein the parallel-conversion optical system includes a transmission type diffraction grating.

A luminous element according to the present invention comprises a linear polarization element for substantially linearly polarizing an emission light.
A luminous element according to the present invention comprises a concave reflecting mirror,

wherein the luminous element is arranged to be an array and used as a luminous device of an image display apparatus,

wherein the luminous element is used as a luminous device of a projection type image display apparatus,

wherein the luminous element is used as a luminous device of a direct-view type image display apparatus,

wherein the luminous element is an electro-luminescent element,

wherein the luminous element is a light emitting diode element,

wherein the luminous device is a field emission display, and the parallel-conversion optical system is unnecessary,

wherein the field emission display also operates as the optical switch, by means of controlling a phosphor emission based an an electron beam on and off,

wherein the optical switch is a digital micro-mirror device composed of arrayed plural mirrors,

wherein the luminous device is composed of plural light sources arrayed on a curved surface,

wherein the curved surface has its curvature center on an optical axis of beams input into the optical switch,

wherein the curved surface is a concave surface, and

wherein the curved surface is a convex surface.

BRIEF DESCRIPTION OF THE DRAWINGS

Fig. 1 shows a configuration of a liquid crystal projector according to the present invention;
Fig. 2 shows a configuration of LD array 51 and lens array 61, according to the present invention;
Fig. 3 shows a front view of the LD array 51 according to the present invention;
Fig. 4 shows a perspective view of a semiconductor laser 54, according to the present invention;
Fig. 5 shows a beam-conversion optical system 65 according to the present invention;
Fig. 6 shows another example of the LD array 51 according to the present invention;
Fig. 7 shows a surface-emitting semiconductor laser 56 according to the present invention;
Fig. 8 shows a perspective view of the surface-emitting semiconductor laser 56 according to the present invention;
Fig. 9 shows another example of the liquid crystal projector according to the present invention;
Fig. 10 shows another example of the liquid crystal projector according to the present invention;

Fig. 11 shows another example of the liquid crystal projector according to the present invention;
Fig. 12 shows an operation of polarization beam splitter 41 and reflection type liquid crystal panel 76, according to the present invention;
Fig. 13 shows another example of the liquid crystal projector according to the present invention;
Fig. 14 shows a configuration of liquid crystal projector applying a polymer-dispersed liquid crystal panel 75, according to the present invention;
Fig. 15 shows a configuration of liquid crystal projector applying a lamp array 57, according to the present invention;
Fig. 16 shows a perspective view of the lamp array 57 according to the present invention;
Fig. 17 shows a front view of the lamp array 57 according to the present invention;
Fig. 18 shows a unified lamp array 57 and polarization-conversion system 85, according to the present invention;
Fig. 19 shows a configuration of unified single plate type liquid crystal projector according to the present invention;
Fig. 20 shows a discharge lamp 58 according to the present invention;
Fig. 21 shows another configuration of the lamp array 57 according to the present invention;
Fig. 22 shows another configuration of the lamp array 57 according to the present invention;
Fig. 23 shows a liquid crystal projector for combining a color image and a luminance image, according to the present invention;
Fig. 24 shows a liquid crystal projector applying a white laser 39, according to the present invention;
Fig. 25 shows the white laser 39 and the beam-conversion optical system 65, according to the present invention;
Fig. 26 shows a light source applying a linear polarization element 49, according to the present invention;
Fig. 27 shows another light source applying the linear polarization element 49, according to the present invention;
Fig. 28 shows a conventional polarization illumination apparatus;
Fig. 29 shows a first lens plate of the conventional polarization illumination apparatus;
Fig. 30 shows a polarization separation prism array of the conventional polarization illumination apparatus;
Fig. 31 shows a conventional projection type display apparatus;
Fig. 32 shows comparison regarding conventional lamps;
Fig. 33 shows an emission distribution according to a conventional art;
Fig. 34 shows a conventional lamp;
Fig. 35 shows an optical path length and a light shading, according to a conventional art;

Fig. 36 shows a light-utilizing rate according to a conventional art;

Fig. 37 shows the LD array 51 and the beam-conversion optical system 65, according to the present invention;

Fig. 38 shows the LD array 51 and the beam-conversion optical system 65, according to the present invention;

Fig. 39 shows the LD array 51 according to the present invention;

Fig. 40 shows the LD array 51 and the beam-conversion optical system 65, according to the present invention;

Fig. 41 shows the LD array 51 and the beam-conversion optical system 65, according to the present invention;

Fig. 42 shows the LD array 51 according to the present invention;

Fig 43 shows a conventional three color image projector;

Fig. 44 shows a liquid crystal projector of single plate type applying time-sharing system, according to the present invention;

Fig. 45 shows another liquid crystal projector of single plate type applying time-sharing system, according to the present invention;

Fig. 46 shows the beam-conversion optical system applying a modified curve surface lens 151, according to the present invention;

Fig. 47 shows an intensity distribution and an included energy, according to the present invention;

Fig. 48 shows a corresponding relation of the included energy, according to the present invention;

Fig. 49 illustrates calculating a specific angle (phase contrast) for a beam, according to the present invention;

Fig. 50 shows a configuration of a liquid crystal projector applying the modified curve surface lens, according to the present invention;

Fig. 51 illustrates collecting lights by using a general lens;

Fig. 52 illustrates collecting lights by using the modified curve surface lens, according to the present invention;

Fig. 53 shows a compared relation in the case of the modified curve surface lens and the general lens being applied, according to the present invention;

Fig. 54 shows an example of a beam conversion for a laser, according to the present invention;

Fig. 55 shows a direct-view type display apparatus applying a time-sharing system, according to the present invention;

Fig. 56 shows a direct-view type display apparatus applying a time-sharing system with using no liquid crystal panel, according to the present invention;

Fig. 57 shows a direct-view type display apparatus applying a time-sharing system, according to the present invention;

Fig. 58 shows a projection type display apparatus applying a time-sharing system, according to the present invention;

Fig. 59 shows a positional relation between the semiconductor laser and a lens, according to the present invention;

Fig. 60 shows luminous flux on the liquid crystal panel, according to the present invention;

Fig. 61 shows an optical system for making the luminance even, according to the present invention;

Fig. 62 shows a design example of optical system for making the luminance even, according to the present invention;

Fig. 63 shows a first lens arrangement in the No. 1 design example, according to the present invention;

Fig. 64 shows the first lens arrangement in the No. 2 design example, according to the present invention;

Fig. 65 shows a perspective view of first lens array according to the present invention;

Fig. 66 shows an irradiation optical system (narrow angle), according to the present invention;

Fig. 67 shows an irradiation optical system (wide angle), according to the present invention;

Fig. 68 shows an optical system of integrated array light source, according to the present invention;

Fig. 69 shows an optical system for making the luminance even by using a diffraction grating, according to the present invention;

Fig. 70 shows a configuration of an organic EL element, according to the present invention;

Fig. 71 shows another configuration of the organic EL element, according to the present invention;

Fig. 72 shows another configuration of the organic EL element, according to the present invention;

Fig. 73 shows another configuration of the organic EL element, according to the present invention;

Fig. 74 shows another configuration of the organic EL element, according to the present invention;

Fig. 75 shows a projection type projector applying a luminous device of white EL element array, according to the present invention;

Fig. 76 shows a projection type projector applying a luminous device of organic EL element array, according to the present invention;

Fig. 77 shows a configuration of LED element, according to the present invention;

Fig. 78 shows another configuration of LED element, according to the present invention;

Fig. 79 shows a configuration of FED, according to the present invention;

Fig. 80 shows a configuration of projection type projector applying FED, according to the present invention;

Fig. 81 shows another configuration of projection type projector applying FED, according to the present invention;

Fig. 82 shows an optical system of DMD, according to the present invention;

Fig. 83 shows an operation of DMD, according to the present invention;

Fig. 84 shows a configuration of projection type projector applying DMD, according to the present invention; and

Fig. 85 shows another configuration of projection type projector applying DMD, according to the present invention.

THE BEST MODE FOR REALIZING THE INVENTION

Embodiment 1.

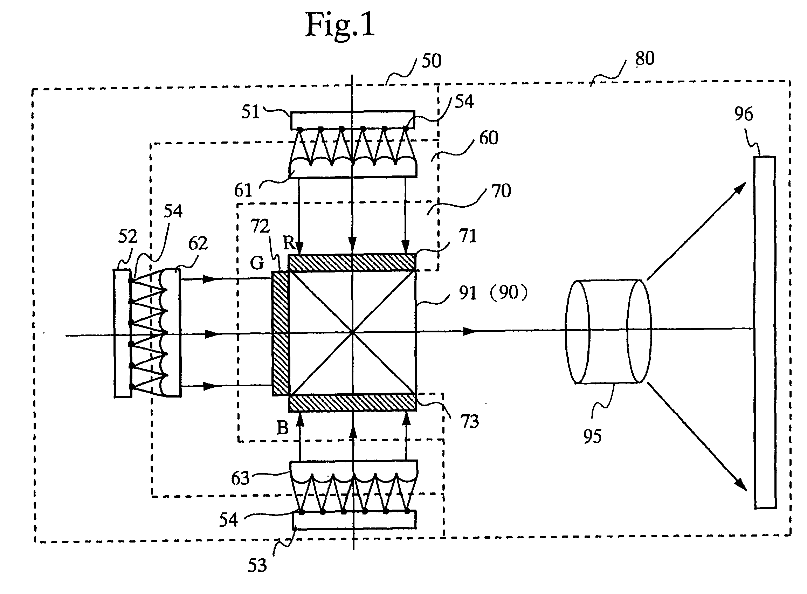

Fig. 1 shows a liquid crystal projector employing transmission type liquid crystal panels, as an example of image display apparatus according to the present invention. The liquid crystal projector is composed of a luminous device 50, a parallel-conversion optical system 60, an optical switch 70, and a display optical system 80. The luminous device 50 is composed of an LD (laser diode) array 51 emitting red, an LD array 52 emitting green, and an LD array 53 emitting blue. The parallel-conversion optical system 60 is composed of a lens array 61, a lens array 62, and a lens array 63. The optical switch 70 is composed of a red-transmission type liquid crystal panel 71, a green-transmission type liquid crystal panel 72 and a blue-transmission type liquid crystal panel 73. The display optical system 80 is composed of a combining optical system 90, a projection lens 95 and a screen 96. The combining optical system 90 is composed of a cross dichroic prism 91 (or cross dichroic mirror).

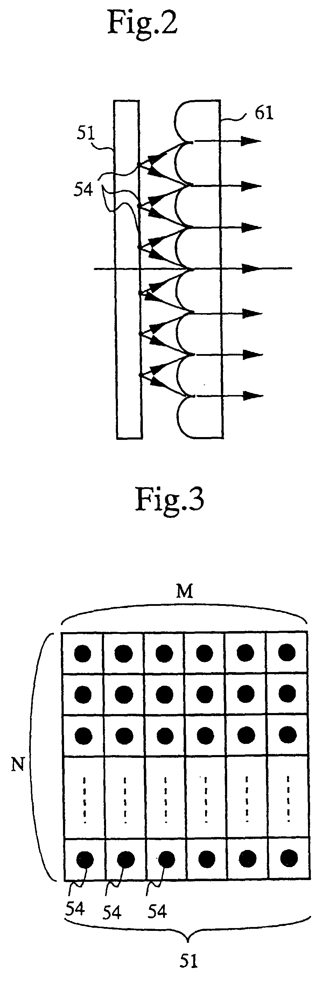

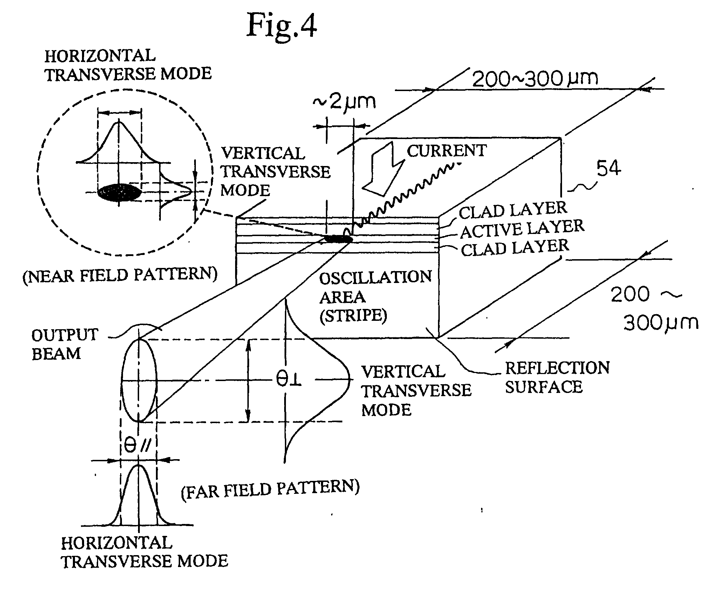

The cross dichroic prism 91 is used in Fig. 1, which leads the advantage that lengths of R, G, and B rays are equivalent. Fig. 2 shows the LD array 51 and the lens array 61. Fig. 3 shows a front view of the LD array 51. The LD array 51 as shown in Figs. 2 and 3 is composed of semiconductor lasers 54 of M x N. Fig. 4 shows a configuration of the semiconductor laser 54. The LD array 51 of Fig. 3 is composed of the semiconductor lasers 54 of Fig. 4 being piled up lengthwise and crosswise and fixed by using a method such as bonding. As shown in Fig. 4, the semiconductor laser 54 has a double hetero-structure and is sometimes called a laser diode (LD).

As the laser diode (LD), GaN can be used for blue, ZnSe or the second harmonic (generation of half wave) of GaAsP (wavelength: approximately 1.10 μm) can be used for green, and A1GaInP (wavelength: around 658 nm) can be used for red. The output beam from the semiconductor laser 54 is polarized in parallel to the hetero junction surface. Namely, a linearly polarized beam (a wave P or a wave S) is oscillated from the semiconductor laser 54. The polarization-conversion optical system which has been conventionally used is not needed by way of corresponding the direction of the linearly polarized beam output from the semiconductor laser to the direction of the linearly polarized beam utilized by each of the liquid crystal panels 71, 72 and 73.

The output beam from the semiconductor laser 54 diverges as shown in Fig. 4. Namely, the output beam from the semiconductor laser 54 is not a parallel beam. The feature of the output beam can be obtained by measuring a far field pattern. The far field pattern as shown in Fig. 4 is known to distribute like the shape of a bell, being symmetrical with respect to the center axis, that is called Gaussian distribution. This far field pattern changes depending upon the distance from the semiconductor laser 54. The output beam from the semiconductor laser 54 can be converted to a parallel beam, by placing the lens array 61 to be corresponding with the feature of the far field pattern. Namely, parallel beams can be obtained by deciding the lens specification of the lens array 61 based on the distance between the LD array 51 and the lens array 61. As shown in Fig. 2, when the lens array 61 is located at the place where output beams from the neighboring semiconductor lasers 54 just meet each other, parallel beams having a wholly uniform luminance distribution can be made.

As stated above, since the output beams oscillated from the semiconductor lasers 54 are linearly polarized beams which can be utilized by each of the liquid crystal panels 71, 72 and 73, the polarization-conversion optical system conventionally used is not necessary. Accordingly, a liquid crystal projector having a very simple optical system configuration can be manufactured. Besides, the integrator optical system conventionally used also becomes unnecessary. Consequently, a display apparatus being small and low-cost can be realized.

A feature of the present embodiment is that output beams from the LD array 51 are directly input into the lens array 61. Namely, an output beam from the semiconductor laser 54 is directly input into the lens array 61 without using a wave guide or an optical fiber. Semiconductor lasers 54 are located, in the array state, at where beams from the semiconductor lasers 54 can be directly input into the lens array 61.

Besides, since the luminous device 50 being the array, parallel beams having the same shape or a similar shape to the liquid crystal panel are generated and all the generated beams are utilized, which enormously enhances the light-utilization rate.

As shown in Fig. 4, since the oscillation range is equal to or less than 2μm (micro meter), it can be almost regarded that the light source is a point light source. Accordingly, comparing with the conventional lighting equipment, it is possible to generate parallel beams closer to the perfect parallel than the conventional ones.

As the size of the resonator of the semiconductor laser 54 is 200μm through 300μm as shown in Fig. 4 and the reflecting mirror conventionally used is not installed, the whole size of the apparatus can be small. For instance, in the case of the liquid crystal panel whose size is around 1.3 inches being used, the diameter of the main reflecting mirror needs to be about 8 cm as set forth above. However, according to the present invention, it is enough to use the luminous device 50 whose diagonal length is 1. 3 inches even when a beam of 1.3 inches diagonally long is directly generated by using the luminous device 50. Accordingly, the apparatus is enormously downsized.

The semiconductor laser arrayed two-dimensionally as stated above is a semiconductor laser outputting multi-mode laser beams or laser beams of wide spectrum. The multi-mode in here indicates that modes of beams output from the optical resonator are plural. The aim of outputting multi-mode laser beams or laser beams of wide spectrum is to reduce a speckle pattern or avoid generating a speckle pattern. If speckles generate, the screen glaringly shines and becomes dazzling and unclear. The speckle is a phenomenon that coherent beams having coincident phases mutually interfere and consequently a light intensity distribution being spatially lumpy is generated.

The coherence length (interference distance) $\delta(\lambda_m)^2/\delta\lambda$ ( $\lambda_m$ : average wavelength, $\delta\lambda$ : wavelength width) becomes shorter according as the wavelength width $\delta\lambda$ becomes wide. Consequently the interference lessens (meaning to become incoherent beams) in accordance with it. Therefore, it is desirable to use the multi-mode laser beams or the laser beams of wide spectrum in order to reduce the speckle. In addition, it is desirable for the average length $\lambda_m$ of each laser beam to be different.

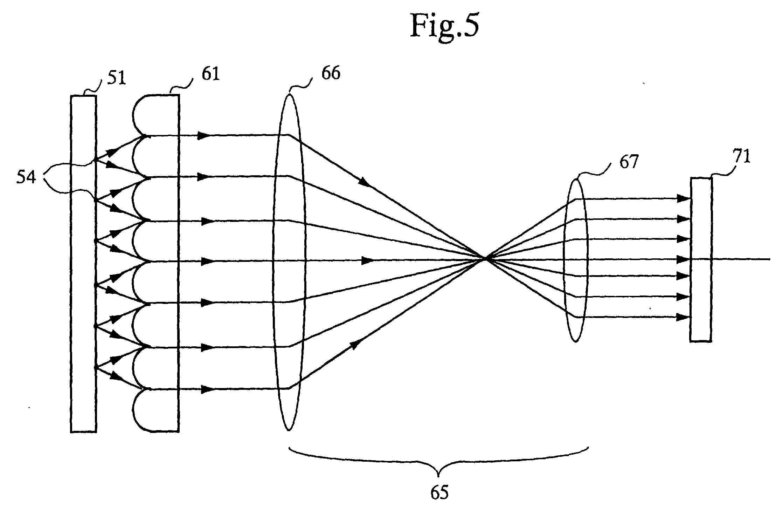

Fig. 5 shows the case of applying a beam-conversion optical system 65. The beam-conversion optical system is composed of convex lenses 66 and 67. When the size of the LD array 51 does not coincide with that of the red-transmission type liquid crystal panel 71, as shown in Fig. 5, the beam-conversion optical system 65 is set up between the lens array 61 and the red-transmission type liquid crystal panel 71 in order to convert the section size of parallel beams. If the red-transmission type liquid crystal panel 71 is larger than the LD array 51, though not shown, the beam size is converted to be extended, by inverting the locations of the convex lens 66 and the convex lens 67 in Fig. 5. Accordingly, the LD array 51 can be smaller by setting up the beam-conversion optical system 65.

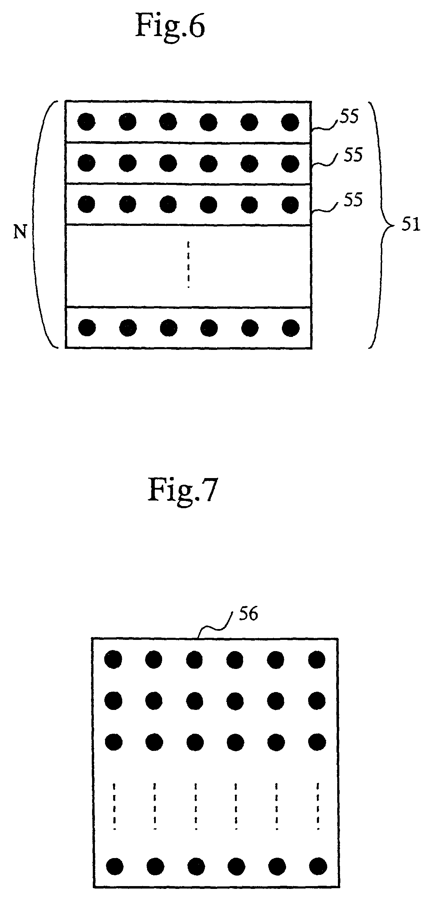

Fig. 6 shows another example of the LD array 51. The LD array 51 is composed of semiconductor lasers 55 of N layers. The semiconductor laser 55 is a collection of laser diodes unified in a lateral row. The semiconductor laser 55 can be manufactured by using a semiconductor integrated circuit. It is also acceptable, though not shown, to manufacture the LD array 51 by using a semiconductor integrated circuit.

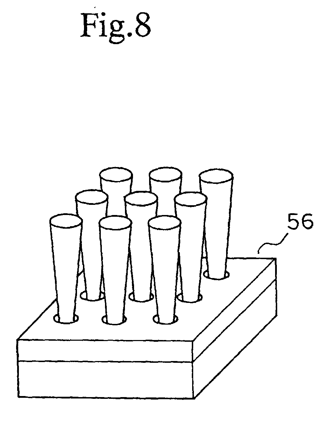

Fig. 7 shows a surface-emitting semiconductor laser 56. The surface-emitting semiconductor laser 56 is made of laser diodes generating output beams vertically with respect to the active layer as shown in Fig. 8. The resonator length of the surface-emitting semiconductor laser 56 is around 1 µm through 2 µ m, whereas the resonator length of the semiconductor laser 54 shown in Fig. 4 is 200 µm through 300 µm. Therefore, the size can be smaller. The output beams are circular beams. A laser array being high-dense and two-dimensional can be provided as shown in Fig. 8. As to the output beams from the surface-emitting semiconductor laser 56, being linearly polarized beams, it is said to be difficult performing a fixed-direction polarization control for each of the beams. However, some cases succeeded in the polarization control by changing the surface direction of the substrate, applying quantum dots to the active layer, or installing a diffraction grating metal mirror, have been reported.

Namely as set forth, it is possible to control the polarization direction of plural beams from the surface-emitting semiconductor laser 56 to be fixed. Then, an array can be formed with the surface-emitting semiconductor laser 56 to be the luminous device 50.

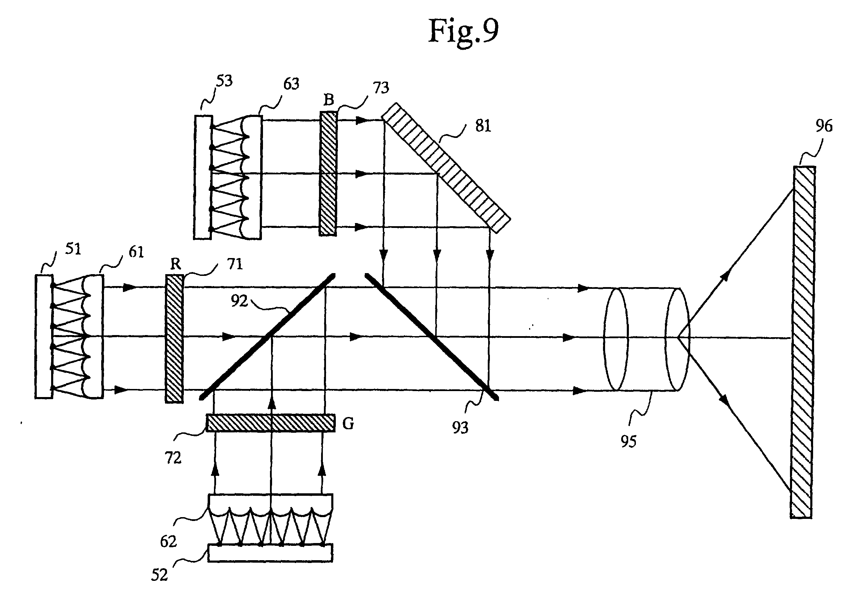

Fig. 9 shows another example of the liquid crystal projector. The feature of Fig. 9 is that dichroic mirrors 92 and 93 are used instead of the cross dichroic prism 91 (or a cross dichroic mirror). Comparing with the cost in the case of using the cross dichroic prism 91 or cross dichroic mirror, the cost of the optical system using the dichroic mirrors is lower. Besides, the advantage that the light lengths of R, G, and B are equivalent is achieved by composing as Fig. 9.

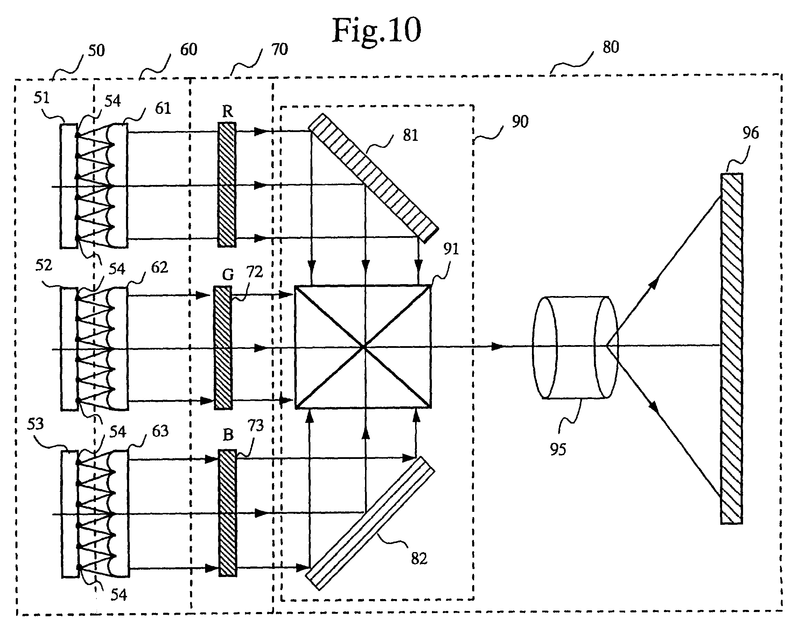

Fig. 10 shows another example of the liquid crystal projector. The combining optical system 90 is composed of reflecting mirrors 81 and 82, and the cross dichroic prism 91 (or a cross dichroic mirror).

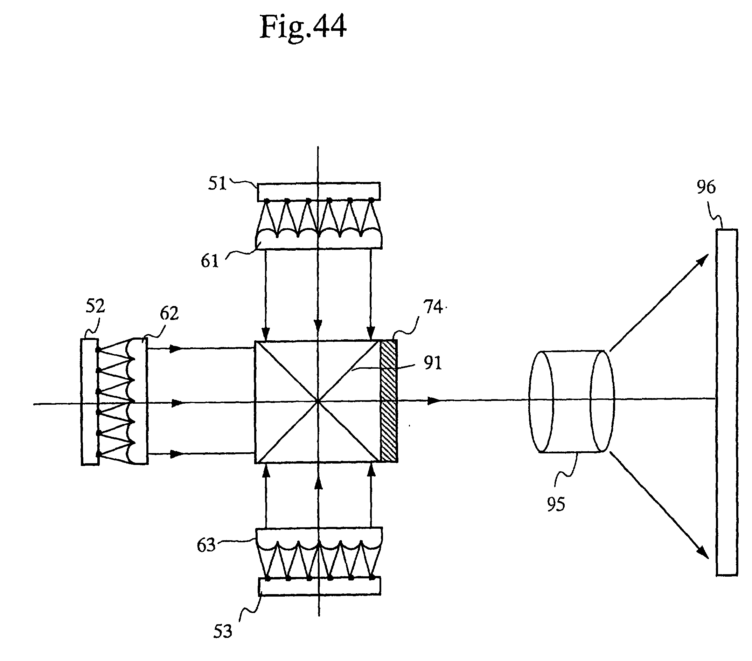

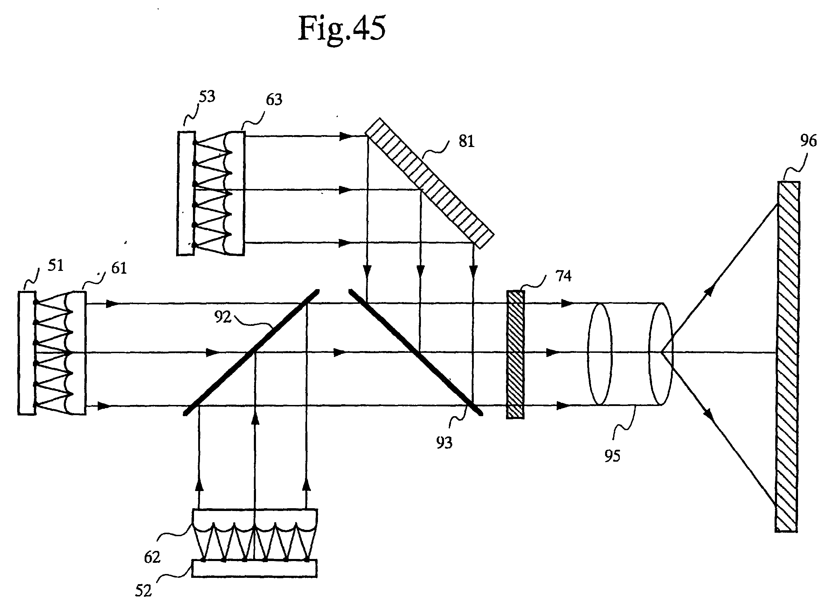

Three liquid crystal panels are used in Figs. 1, 9 and 10. It is also acceptable to apply time-division system (time-sharing system) by using one liquid crystal panel 74 as shown in Figs. 44 and 45. In this case, the liquid crystal panel 74 needs to have the switching speed three-times as fast as usual. The response speed of a regular TN type (twisted nematic type) liquid crystal is 10 through several decades ms. Therefore, a ferroelectric liquid crystal whose response speed is around 0.1 ms or a semi-ferroelectric liquid crystal whose response speed is around 1.5 ms can be used for this case.

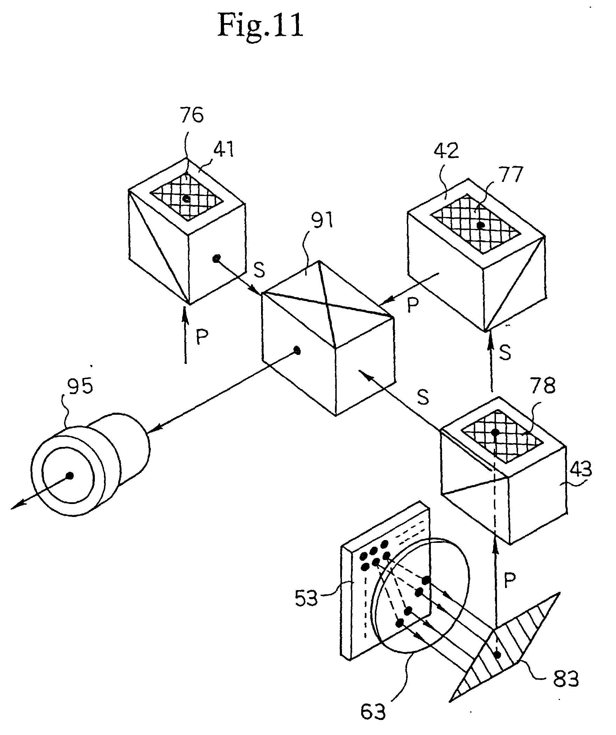

Fig. 11 shows a configuration of a liquid crystal projector applying a reflection type liquid crystal panel. The liquid crystal projector of Fig. 11 is composed of reflection type liquid crystal panels 76, 77 and 78 and polarization beam splitters 41, 42 and 43.

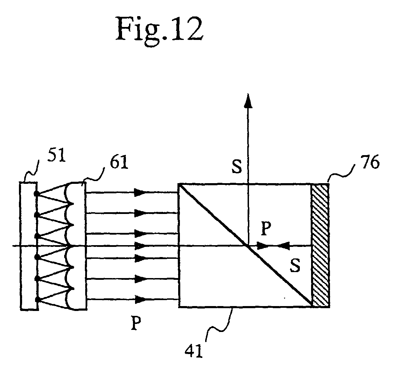

Fig. 12 shows an operation basic of the polarization beam splitter 41 and the reflection type liquid crystal panel 76. When a wave P is generated by the LD array 51, the wave P is transmitted through the polarization beam splitter 41 to be projected on the reflection type liquid crystal panel 76. A Reflected ray from the reflection type liquid crystal panel 76 returns to the polarization beam splitter 41 as a wave S. Since the polarization beam splitter 41 reflects the wave S, a ray reflected by the polarization beam splitter 41 goes in the right-angled direction with respect to the wave P.

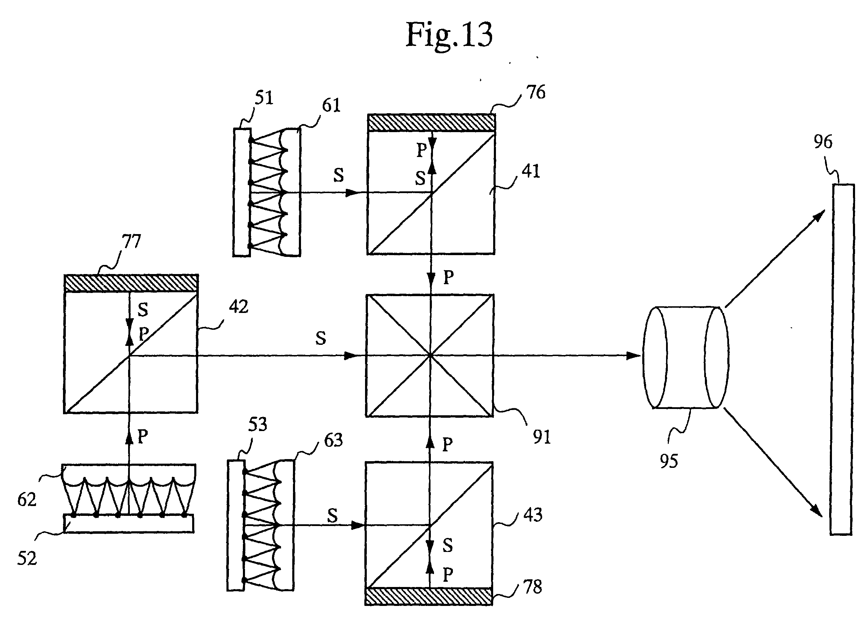

Fig. 13 shows another configuration of liquid crystal projector applying the reflection type liquid crystal panel as well as Fig. 12. The advantage of the configuration shown in Fig. 13 is that the light lengths of R, G, and B are equivalent on the plane allocation.

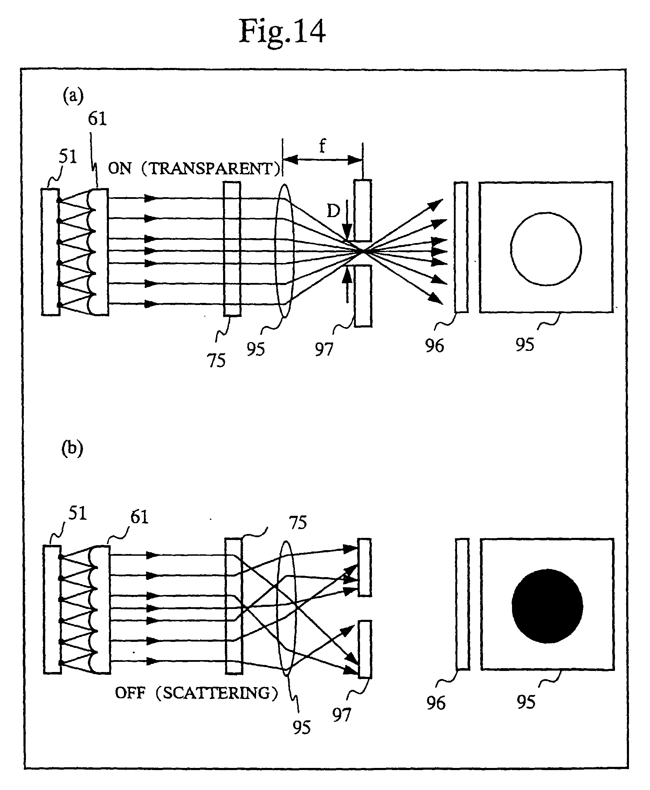

Fig. 14 shows a configuration applying a polymer-dispersed liquid crystal panel. In Fig. 14, a polymer-dispersed liquid crystal panel 75, the projection lens 95 and a pin hole plate 97 are installed between the lens array 61 and the screen 96. Fig. 14 (a) shows the state that the polymer-dispersed liquid crystal panel 75 is ON and an image is displayed. Fig. 14 (b) shows the state that the polymer-dispersed liquid crystal panel 75 is OFF and no image is displayed. The feature of the configuration in which the polymer-dispersed liquid crystal panel 75 and the projection lens 95 are assembled is that high-contrast can be achieved because radiated rays are parallel beams. The smaller a pin hole diameter D of the pin hole plate 97 is, the better the contrast ratio becomes. It is necessary that the beam condensing rate of the projection lens 95 is high, in order to make the diameter D of the pin hole small. Therefore, it is desirable for incident beams into the projection lens 95 to have a high parallel degree.

As set forth above, it is essential for the liquid crystal projector applying the polymer-dispersed liquid crystal panel to receive, beams having a high parallel degree. By using the LD array 51 of the present invention, beams of a high parallel degree can be generated.

The polymer-dispersed liquid crystal panel operates regardless of the polarization direction of incident beams. Therefore, whatever beam wave the LD array 51 outputs, that is either a wave S or a wave P, or both the waves S and P, the polymer-dispersed liquid crystal panel operates without any problems.

By using the LD array 51 and the lens array 61 of the present invention, the contrast ratio of the liquid crystal projector applying the polymer-dispersed liquid crystal panel is increased and a utilizing efficiency of optical energy is enhanced.

In addition, it is acceptable to apply the present invention not only to the liquid crystal projector but also to a direct-view type liquid crystal display apparatus which will be stated in Embodiment 6. The present invention has an advantage that a color filter can be unnecessary.

In Fig. 3, the case that semiconductor lasers 54 are arrayed to compose the LD array 51 is shown. It is also acceptable to array light emitting diodes (LED), electro-luminescence lamps (EL), discharge lamps, or other luminous devices instead of the semiconductor lasers 54.

Embodiment 2.

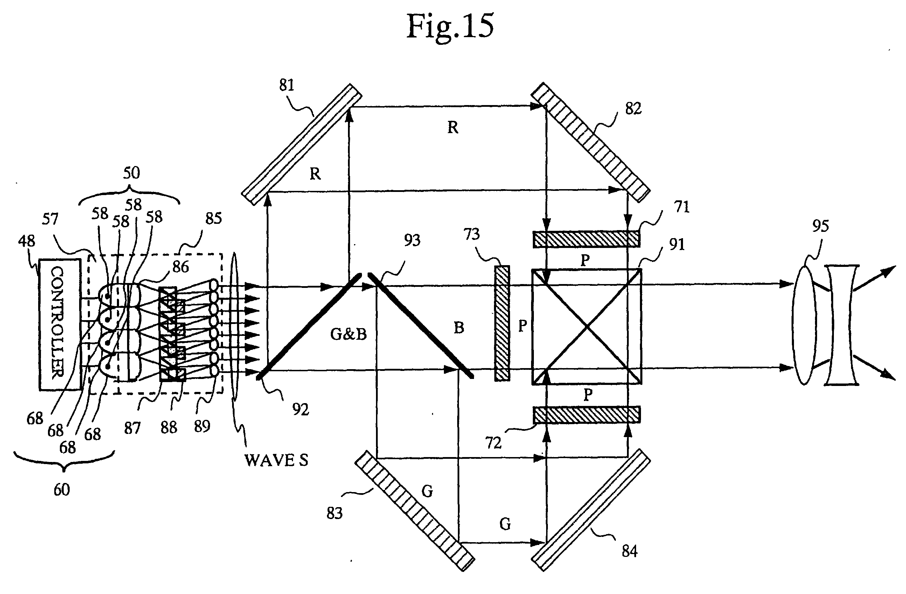

Fig. 15 shows a liquid crystal projector according to the present invention. In Fig. 15, the luminous device 50 is composed of arrayed plural discharge lamps 58 and the parallel-conversion optical system 60 is composed of arrayed plural reflectors 68. A lamp array 57 is composed of the discharge lamps 58 and the reflectors 68. A polarization-conversion system 85 is composed of a lens array 86, a polarization beam splitter 87, a $\lambda/2$ plate 88 and a lens array 89. The lamp array 57 is composed of arrayed micro lamps or mini lamps.

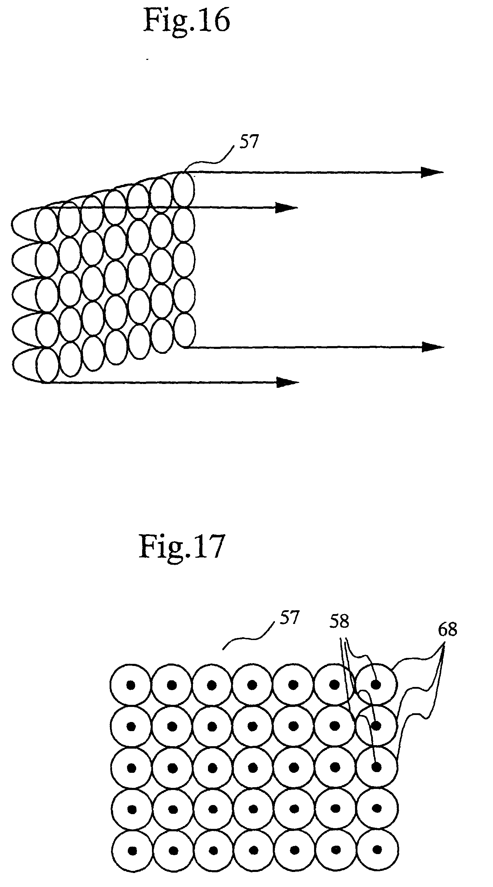

Fig. 16 shows a perspective view of the lamp array 57, and Fig. 17 shows a front view of it. The lamp array 57 is composed of arrayed discharge lamps 58 and reflectors 68 corresponding to the discharge lamps 58.

The arc length can be short since the small lamps stated above are used. Therefore, the reflected lights from the reflectors 68 can be closer to the perfect parallel beams. Namely, parallel beams are output from the lamps having point source lamps. A controller 48 controls light emission of each discharge lamp 58 in the lamp array 57. The controller 48 can respectively turn on or off the discharge lamps 58, and change the light emission amount of the discharge lamp 58. Luminance can be variable by respectively controlling output beams from the discharge lamps 58. By dint of making the luminance variable, it becomes possible to remove unevenness in the projected image and make the luminance uniform. It is also possible to change the beam section shape to be a rectangle, square, triangle or circle by selecting discharge lamps 58 to be emitted, based on the control of the controller 48. Namely, light emission having no useless lights can be made by turning on only the discharge lamps 58 arranged to be the same shape as the lights to be used.

Parallel beams output from the lamp array 57 are input into the lens array 86. The beams through the lens array 86 are collected onto the polarization beam splitter 87. Only waves P are passed through the lens array 86 and waves S are reflected. The reflected waves S are reflected by the mirror and input into the $\lambda/2$ plate 88. The input waves S are converted into waves P by the $\lambda/2$ plate 88 and output. The lens array 89 converts the waves P output from the polarization beam splitter 87 and the $\lambda/2$ plate 88, into parallel beams. These parallel beams are separated by using the dichroic mirror 92 and the dichroic mirror 93.

Red beams separated by the dichroic mirror 92 are reflected by the reflecting mirrors 81 and 82, and input into the red-transmission type liquid crystal panel 71. Green beams separated by the dichroic mirror 93 are reflected by the reflecting mirrors 83 and 84, and input into the green-transmission type liquid crystal panel 72. Beams modulated by the red-transmission type liquid crystal panel 71, the green-transmission type liquid crystal panel 72, and the blue-transmission type liquid crystal panel 73 are combined by the cross dichroic prism 91 (or cross dichroic mirror). Then, the combined beams are output to the projection lens 95.

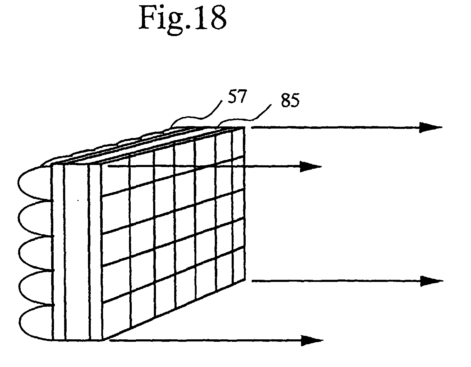

Fig. 18 shows a perspective view of unified lamp array 57 and polarization-conversion system 85. Down-sizing can be accomplished by unifying as the above.

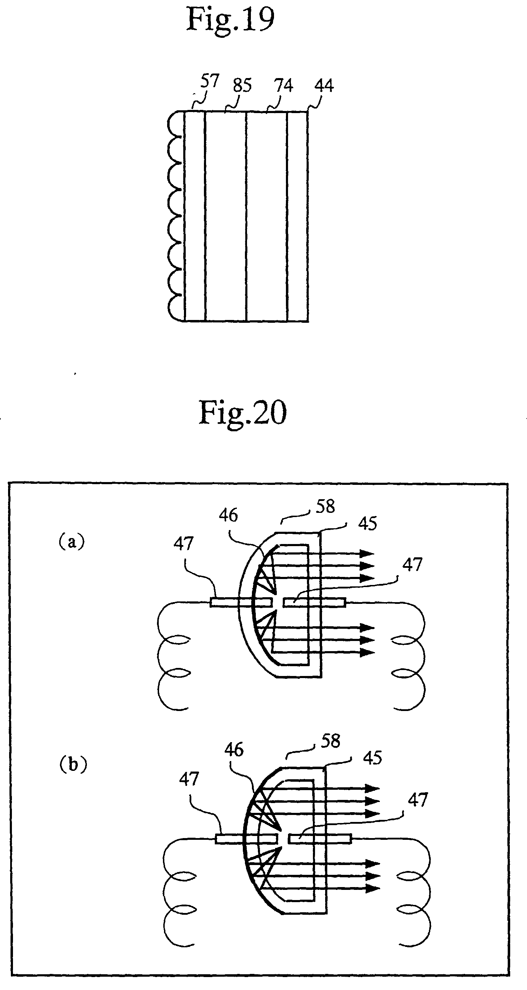

Fig. 19 shows a liquid crystal display apparatus of single plate type. This liquid crystal display apparatus is made by combining the transmission type liquid crystal panel 74 of a single plate type and a color filter 44 to the unified lamp array 57 and the polarization-conversion system 85 shown in Fig. 18.

By unifying the transmission type liquid crystal panel 74 of a single plate type and the color filter 44, a smaller display apparatus can be realized.

Fig. 20 illustrates the case of a reflection layer 46 being provided at a part of the discharge lamp 58. The reflection layer 46 can be provided on the inside wall of a glass 45 as shown in Fig. 20 (a), or on the outside wall of the glass 45 as shown in Fig. 20 (b). Beams emitted between electrodes 47 are reflected by the reflection layer 46 and output as parallel beams. As the discharge lamp 58 shown in Fig. 20 does not have a separate reflector 68, it is possible to make a micro lamp.

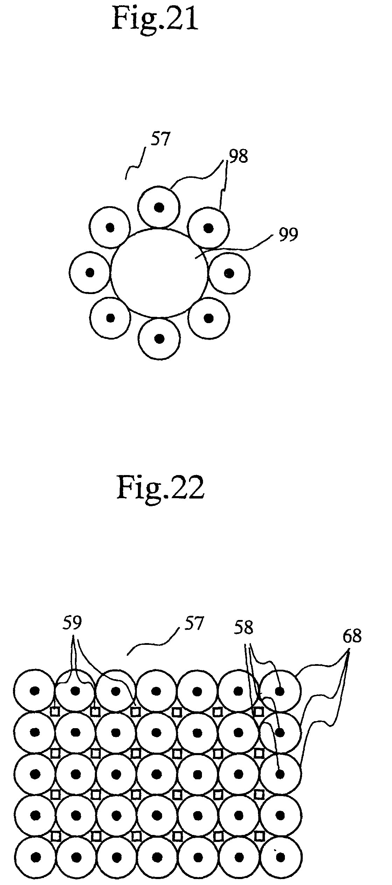

Fig. 21 shows another example of the lamp array 57. The lamp array in Fig. 21 is composed of different size lamps, for instance, a xenon lamp 98 of 100 watt and a metal halide lamp 99 of 400 watt. The xenon lamp 98 and the metal halide lamp 99 have different spectral distributions. Therefore, by aggregating light sources having different spectral distributions, the degree of freedom of selecting a color temperature for a display image can be realized.

The lamp array 57 shown in Fig. 22 has LEDs 59 arranged among the arrangements made by the discharge lamp 58 and reflector 68. It is also acceptable to embed the semiconductor laser 54 or the surface-emitting semiconductor laser 56 instead of the LED 59. The case of Fig. 22 has a merit that light sources having different spectral distributions can be combined.

Besides, in the case of Fig. 21 or Fig. 22, it is possible to select a lamp to be lightened or change a light shape to be emitted, by controlling the controller 48. Fig. 21 or Fig. 22 shows the case that the light source type (various discharge lamps, various LDs, various LEDs, etc.) can be changed and selected, the array shape of the light source can be changed and selected, and that light sources having different sizes are allocated. Then, of course, it is possible to perform other combinations in addition to the cases of Fig. 21 and Fig. 22.

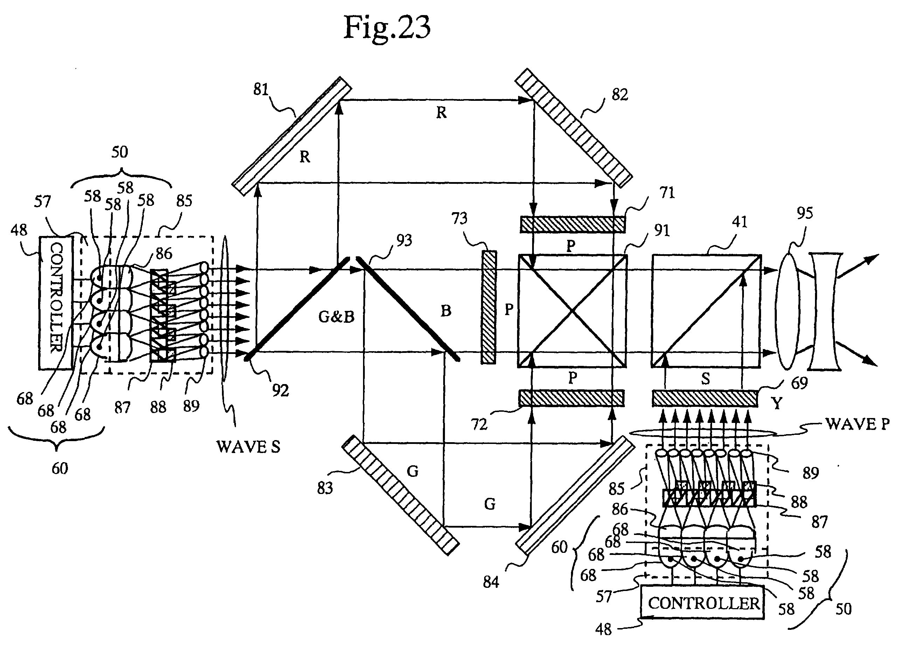

Fig. 23 shows a configuration for realizing higher luminance of the liquid crystal projector shown in Fig. 15. A color screen of R, G, and B is created by using the wave S of the light source, and a luminance screen is created by using the wave P of the light source. By combining the waves P and S with using polarization beam splitter 41, a higher luminance screen can be created. As the conventional liquid crystal projector has one light source, a big light source is needed for realizing high luminance. Besides, since the heating is almost generated in the light source, the cooling has been a large problem to be solved. Also, it has been impossible to avoid effects of the light source spectral distribution characteristic on the image. According to the configuration of Fig. 23, two light sources are provided, so that the high luminance can be realized. Since the two light sources having different spectral distributions are used, it is possible to avoid effects of the light source spectral distribution characteristic on the image. In addition, a light source having a small calorific value can be used for obtaining the same luminance as the conventional art, because two light sources are used. It is also possible to distribute the heat generating place into two places.

Fig. 22 shows the case of the array lamp 57 being used. It is also acceptable to use a lamp, not the array type, as a light source like the conventional art.

As stated above, the case that the discharge lamp whose lamp tube (discharge tube) itself is the reflector has been explained in the present embodiment. The luminous device 50 in which plural lamps are arranged has also been explained. The controller 48 which respectively controls the lamp output of the lamp array 57 in order to make the luminance uniform or make the luminance variable has been explained. Besides, the lamp array 57 is made by aggregating lamps having different spectral distributions has been explained. The lamp array 57 is made by aggregating discharge lamps of short arc (less than 4 mm), each of which has luminance more than hundreds of lm through tens of thousands of lm.

It is also possible to adjust the lamp aggregation with the light-utilizing shape. For instance, if the beam whose section is square is needed, the lamps can be arranged like a square array. If the beam whose section is round is needed, the lamps can be physically arranged like a round aggregated shape.

The beam shape can be controlled based on ON or OFF of the lamp by the controller 48. It is also possible to adjust the lamp array 57 with the size of the light-utilizing shape. It is also possible to put some LEDs, LDs and so on among the lamps of the lamp array 57, or to compose the lamp array 57 of only LEDs, only LDs or only lamps.

The lamp array can be adjusted with the lens array 86. The lens array 86 can be combined with the lamp light-outputting-place.

According to the present Embodiment, it is possible to make the parallel beams output from the lamp large to any extent because the short arc lamps are used.

The light source which is able to project a light amount up to the temperature tolerance of an optical element or the liquid crystal panel located at the downstream of the light beam can be obtained. Besides, an integrator for making the beam uniform is not necessary. The function for making beams uniform by a fry eye lens (array lens) is also unnecessary. As the arc is short (as the point light source is used), it is easy to make parallel beams and a high light-utilizing efficiency is realized.

Converting the beam section from circle to square, which has been conventionally performed, is not necessary. As an effect of this, it is possible to enhance the light-utilizing efficiency equal to or more than 30 percent.

Also, a color temperature can be optionally selected because some spectral distribution light is overlapped.

The luminance of the projector can be changed to a large extent by using the luminance of the light source. In the case of the shape of the lamp array 57 being the same as the light-utilization shape, the optical system or the collective lens located at the downstream of the light beam is not necessary. A color temperature can be further optionally selected by using the LED, LD and so forth as the light source. By making the light source be an array state, optical system components can be omitted. As stated in Embodiment 1, when the linearly polarized beam is utilized, the polarization-conversion system can be omitted, and the heat radiation system can also be omitted because the light-utilization rate is enhanced.

Embodiment 3.

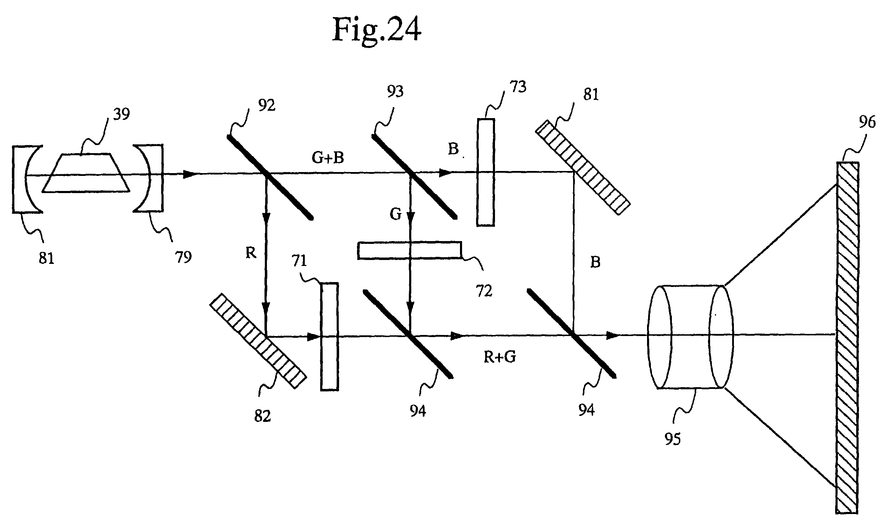

Fig. 24 shows a configuration of the image display apparatus according to the present invention. The feature of Fig. 24 is that a white laser 39 is used as the light source. The white laser 39 outputs linearly polarized beams. As a concrete example of the white laser 39, a gas laser of outside mirror type including a Brewster's window is introduced. The white laser 39 of Fig. 24 includes an element having a Brewster's window and a polarization characteristic, between the reflecting mirror 81 and a half mirror 79. Output beams from the half mirror 79 are linearly polarized parallel beams.

As an example of the white laser, a metal vapor laser can be used. For instance, He-Cd metal vapor laser excited by negative glow plasma can be used.

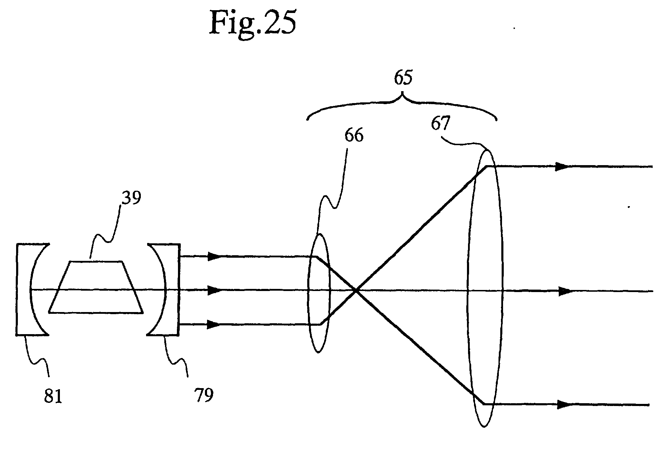

It is also acceptable to provide the beam-conversion optical system 65 for the output beams from the white laser 39, as shown in Fig. 25.

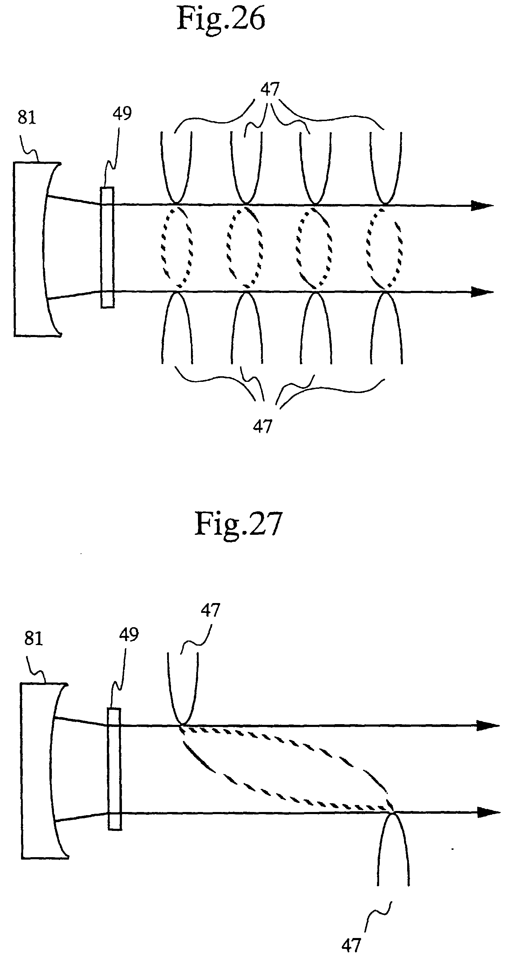

Figs. 26 and 27 show other examples of the light source which outputs a strong beam like the linearly polarized beam. These light sources show examples of utilizing beams based on superradiation. The beam by the superradiation is not a laser beam but is a beam having an extremely high light intensity and a directivity (good spatial coherence) which are led by receiving induced emission. The spectrum width of the beam by the superradiation is much narrower than that of a spontaneous emission light from the LED, EL or etc, but much wider than that of a laser beam (that is, the beam by the superradiation has a short coherence length). The superradiation in here indicates the following spontaneous emission. When a population inversion is formed between two energy levels in physical media composed of atoms or molecules, each atom emits a light having an optical correlation each other. (The light emission having the optical correlation means the emission of photons tending to have similar phases or similar directions.) The intensity of spontaneous emission, not being coherent, from N number of atoms is in proportion to N, while the spontaneous emission intensity by the superradiation is in proportion to $N^2$. In here, it can be defined that the beam by the superradiation includes an amplified spontaneous emission. According to page 66 of "Science of Visual Laser", written by Laser Technique General Research Foundation, published on September 30, 1997, "When a population inversion is formed between two energy levels in physical media, lights by spontaneous emission generate induced emission in the same physical media, and the lights are amplified. Such generated lights are called amplified spontaneous emission. The spontaneous emission is generated everywhere in physical media forming the population inversion. The spontaneous emission radiates in every direction and generates induced emission in the physical media. Therefore, the amplified spontaneous emission is not a coherent light having a directivity such as a light from the laser oscillator including an optical resonator. However, it can not be defined that the spontaneous emission light is not coherent at all or that the spontaneous emission light is incoherent. When the physical media is made to be very long and thin, a light going in the direction of the longer side generates induced emission more often than others, is amplified, and becomes to have some directivity along the direction. Such a light is called a partial coherent light. The light source is appropriate for an application for deleting interference."

Further, in here, it is defined that the beam by the superradiation includes a super luminescent diode (SLD). SLD is a device which has a wide spectrum width like the LED, obtains an amplification effect by the induced emission, and generates high output beams. Namely, the SLD is a luminous device having an emission spectrum characteristic like the LED, and having a high output characteristic and a spatial coherence like those obtained in a semiconductor laser. As a concrete example, SLD having a configuration in which GaInAs/GaInAsP strained quantum well active layer is extended, in the taper state, along the light forwarding direction has been known. The beam by the superradiation, which is not the laser beam, the amplified spontaneous emission light, or the super luminescent diode light has a good directivity and a high intensity, and since its coherence length is short, it is difficult to perform interference. Then, for instance an interference noise such as a speckle pattern is difficult to be generated in such a light.

The light source shown in Fig. 26 or 27 is composed of the electrode 47, reflecting mirror 81 and a linear polarization element 49. Output beams from the light source become linearly polarized beams based on the superradiation, by the linear polarization element 49.

Embodiment 4.

In the present embodiment, the LD array 51 and the beam-conversion optical system 65 stated in Embodiment 1 will now be concretely explained. With respect to the point that the luminance distribution projected on the red-transmission type liquid crystal panel 71 is uniform will also be explained. Though only the LD array 51 and the red-transmission type liquid crystal panel 71 are described in here, the same explanation as the below can be stated for other LD arrays and other liquid crystal panels.

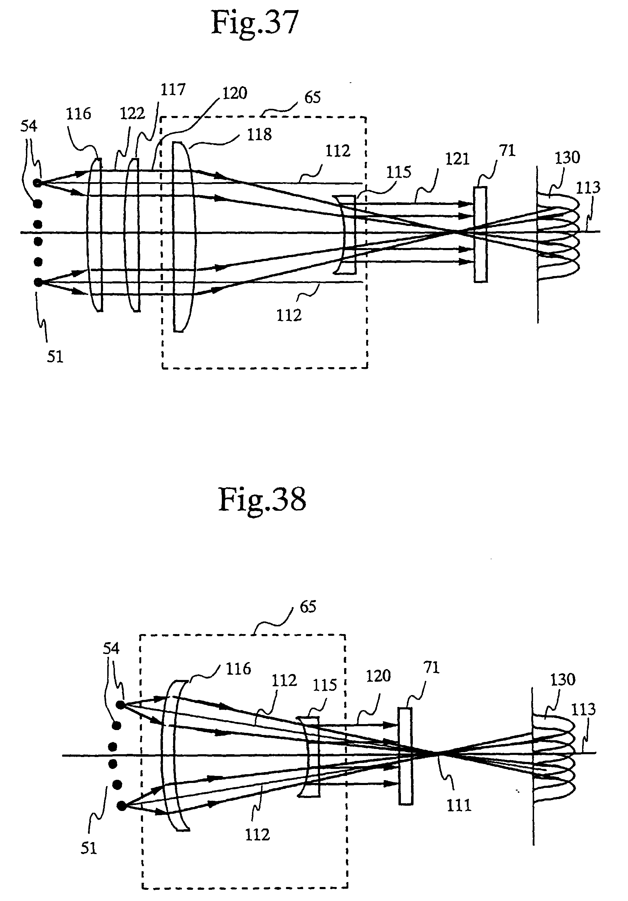

Fig. 37 shows the case that the LD array 51 is larger than the red-transmission type liquid crystal panel 71. In Fig. 37, the semiconductor lasers 54 are arranged on the plane of the LD array 51. Beams emitted from the semiconductor lasers 54 are projected on a convex lens 116. A luminescence center axis 112 of the beams emitted from the semiconductor laser 54 is parallel to a system optical axis 113. As the semiconductor lasers 54 are arranged on the plane, the luminescence center axes 112 of the beams from the semiconductor lasers 54 are parallel to the system optical axis 113. Beams through the convex lens 116 are input into a convex lens 117 as beams 122. Beams through the convex lens 117 become parallel beams 120. The parallel beams 120 are collected by a convex lens 118. Beams from the convex lens 118 are input into a concave lens 115 and converted into parallel beams 121. The parallel beams 121 are projected on the red-transmission type liquid crystal panel 71. A luminance distribution 130 indicates a light distribution projected on the red-transmission type liquid crystal panel 71. Beams emitted from the semiconductor lasers 54 have Gaussian distribution. Beams projected on the red-transmission type liquid crystal panel 71 have uniform luminance distribution because the beams having Gaussian distributions are overlapped .

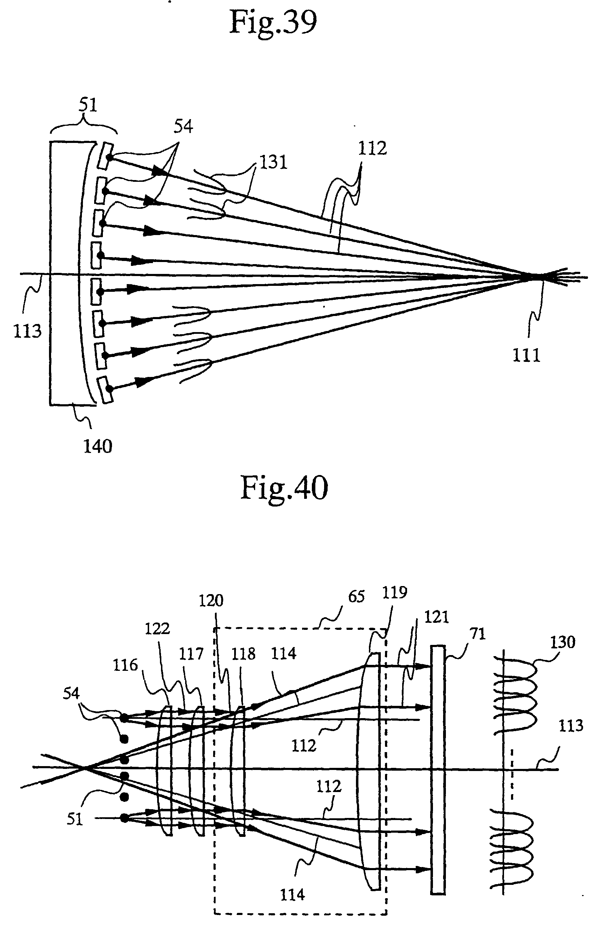

Fig. 38 shows the case of the LD array 51 being curved. Fig. 39 shows the configuration of the LD array 51 of Fig. 38. As shown in Fig. 39, plural semiconductor lasers 54 are two-dimensionally arranged on a concave substrate 140. A center of curvature 111 of the curved surface of the concave substrate 140 exists on the system optical axis 113. Therefore, the luminescence center axes 112 of the semiconductor lasers 54 are converged on the center of curvature 111. The semiconductor lasers 54 on the LD array 51 of Fig. 39 are arranged in order to converge the beams of the semiconductor lasers 54.

As shown in Fig. 38, the luminescence center axes 112 of the beams emitted from the semiconductor lasers 54 are converged on the center of curvature 111 and converted by the beam-conversion optical system 65. The beam-conversion optical system 65 is composed of the convex lens 116 and the concave lens 115. The beams are converted to the parallel beams 120 by the concave lens 115 and projected onto the red-transmission type liquid crystal panel 71. The luminance distribution 130 of the beams projected on the red-transmission type liquid crystal panel 71 becomes, as set forth above, uniform because the beams are overlapped.

Now, the case of the LD array 51 being smaller than the red-transmission type liquid crystal panel 71 will be explained.

Fig. 40 shows the case of the LD array 51 in which the semiconductor lasers 54 are arranged on the plane so that the luminescence center axes 112 of the beams emitted from the semiconductor lasers 54 may be parallel to the system optical axis 113. The beams emitted from the semiconductor lasers 54 become the beams 122 through the convex lens 116, and further become the parallel beams 120 through the convex lens 117. The parallel beams 120 are made to be diverging through the convex lens 118 and input to a convex lens 119. The beams through the convex lens 119 become the parallel beams 121 and projected onto the red-transmission type liquid crystal panel 71. The luminance distribution 130 of this case is also uniform.

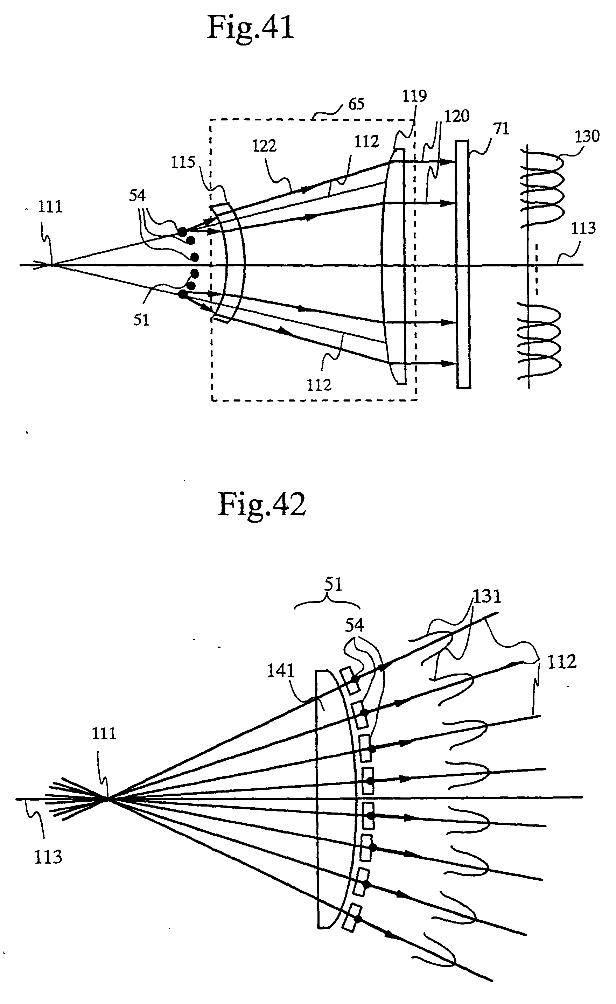

Fig. 42 shows the case that the semiconductor lasers 54 are arranged on the curved surface of the LD array 51. Fig. 42 illustrates the configuration of the LD array 51 of Fig. 41. The plural semiconductor lasers 54 are two dimensionally arranged on a convex substrate 141. The center of curvature 111 of the convex substrate 141 exists on the system optical axis 113. Accordingly, the luminescence center axes 112 of the beams emitted from the semiconductor lasers 54 are converged on the center of curvature 111.

In Fig. 41, the size of the beams emitted from the semiconductor lasers 54 is converted at the beam-conversion optical system 65. The beams emitted from the semiconductor lasers 54 are made to be wide through the concave lens 115 and input to the convex lens 119. The beams input to the convex lens 119 are converted to the parallel beams 120 and projected onto the red-transmission type liquid crystal panel 71. The luminance distribution 130 of this case is also uniform.

Embodiment 5.

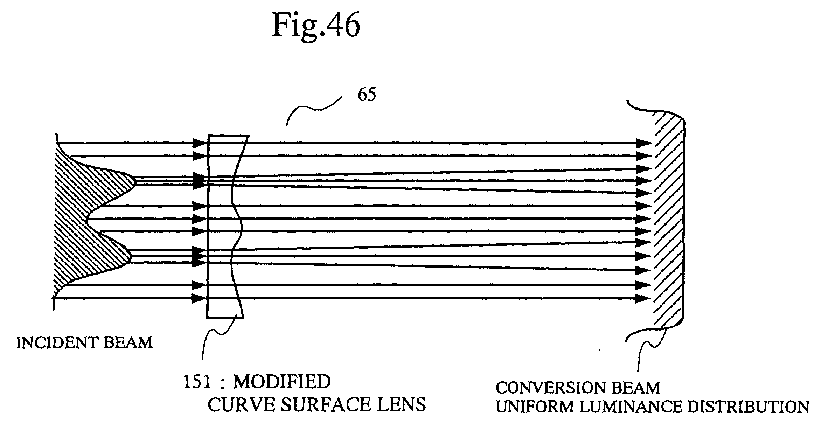

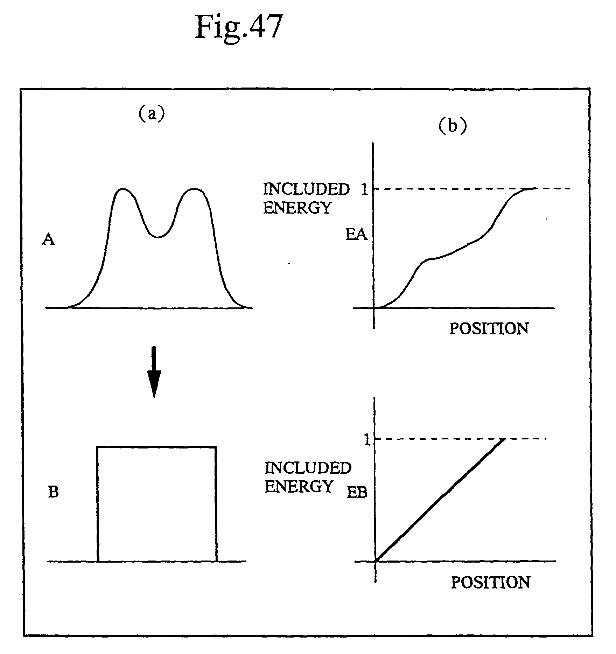

Fig. 46 shows the beam-conversion optical system 65 applying an analog phase control using a modified curve surface lens 151 (aspheric lens). Conventionally, it has been attempted to change the intensity distribution of optical beam depending upon a purpose. For example, the fry eye lens or kaleidoscope is known as a beam homogenizer. These are based on overlapping a lot of beams. As another method, as shown in Fig. 46, it is possible to condense or expand the light intensity of a fine part of an incident beam one by one in order to convert the light intensity distribution to an aimed one. Concretely, the shape of a conversion element can be decided by the following processes (algorithm). To make the explanation simple, it is supposed to have a one-dimensional beam distribution. As an example, the intensity distribution A in Fig. 47 (a) is converted to the intensity distribution B.

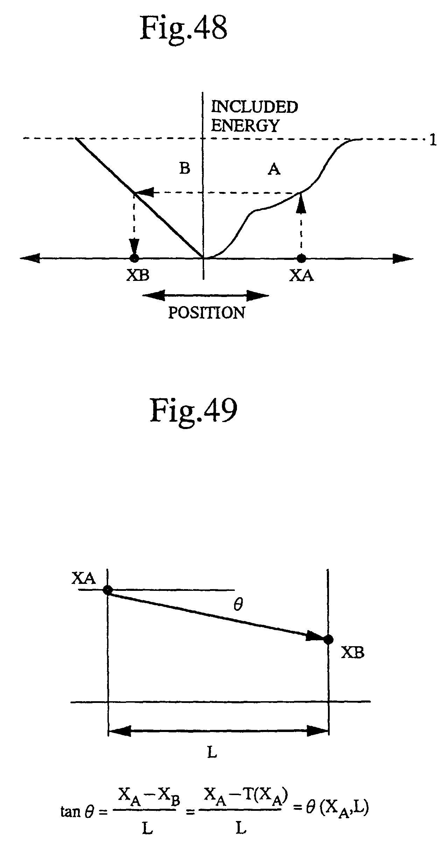

When an included energy of each distribution intensity is integrated with respect to the position, it is supposed to have the state of Fig. 47 (b). As it is supposed to convert 100 %, each included energy of the both is standardized to be 1. When the energy is reapplied from the edge, the correlation between the point $X_A$ on the line A and the point $X_B$ on the line B for performing a desired conversion is shown in Fig. 48. As the included energy is expressed by a monotonic increasing function, the correlation should necessarily be 1 to 1. Therefore, a pair of mapping (coordinate conversion) $X_B = T(X_A)$ can be defined.

As shown in Fig. 49, in order to convert a beam of A to be away by the distance L, it may be enough that rays on A should have an angle θ (phase contrast). The figure of the optical element for giving the angle θ can be easily calculated by the equation shown in Fig. 49.

The conversion element obtained as the result controls the phase of incident beam in analog. Characteristics of the beam forming by the analog phase control are as follows:

* Almost 100 % efficiency can be obtained.

* Beam quality (coherency) is not deteriorated.

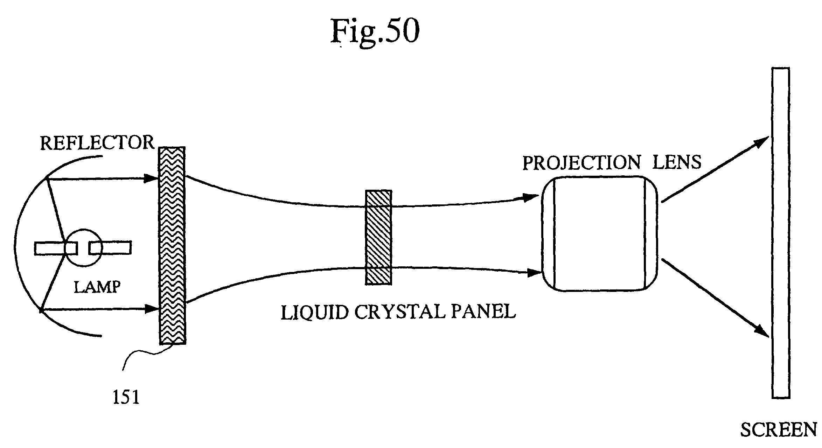

Fig. 50 illustrates the modified curve surface lens 151 based on the analog phase control being applied to the liquid crystal projector. The screen luminance and the uniformity can be improved.

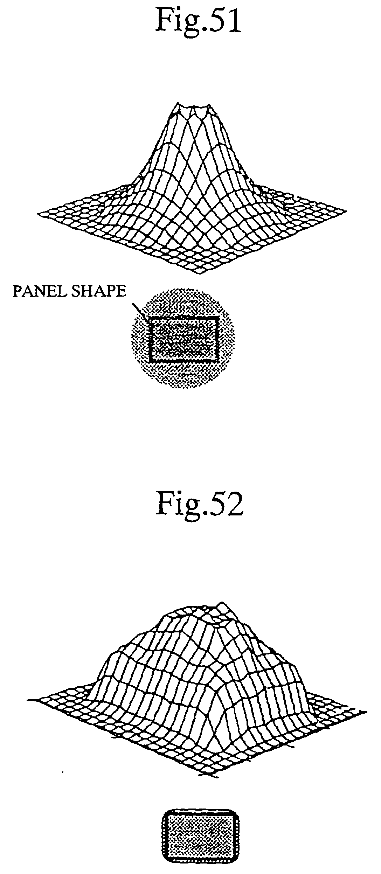

The experiment for proving the principle has been executed by making a modified curve surface lens 151 using acrylic acid resin as a trial and applying the modified curve surface lens 151 to the liquid crystal projector. In the case shown in Fig. 51 of collecting lights by using a general lens, it is necessary to throw away more than half the lights in order to obtain the screen illuminance uniformity because a circle light intensity distribution focused on the central part of the liquid crystal panel is generated. By using the modified curve surface lens 151 as shown in Fig. 52, lights being a rectangle to be suited for the liquid crystal panel shape and having a uniform distribution can be obtained. Consequently, it has been proved as the experiment result shown in Fig.

53 that the uniformity of illuminance distribution on the screen is high and the luminous flux amount on the screen is increased to be more than twice.

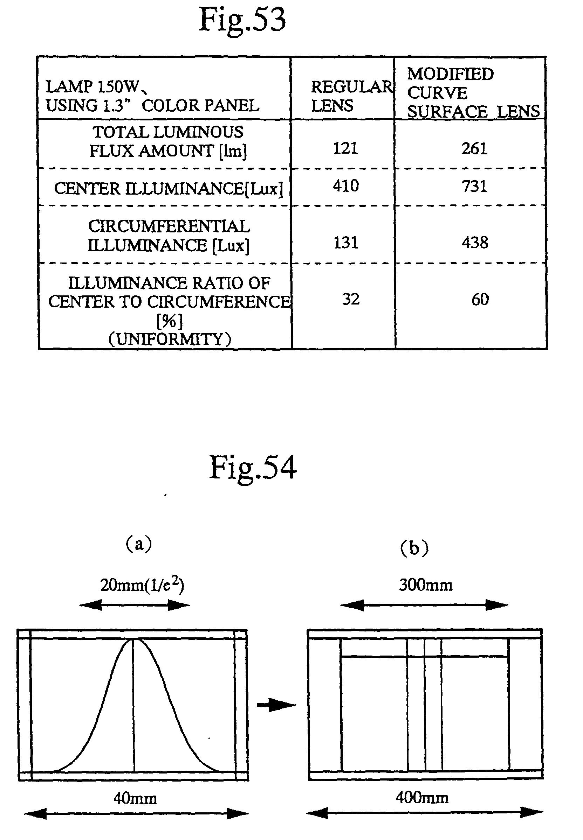

The beam shape conversion theory stated above is also effective in the laser. It is expected that the conversion as shown in Fig. 54 can be achieved without lowering the substantial coherency.

As stated above, parallel beams whose luminance distribution is further uniform can be obtained by using the modified curve surface lens 151. There are two methods as to the luminance distribution uniformity: one is a method of using the modified curve surface lens 151 and the other is described in Embodiment 4 with reference to Figs. 37 through 42. Besides, it is acceptable to combine the two methods.

Embodiment 6.

In the above Embodiment, the projection type display apparatus has been explained. In the present Embodiment, direct-view type display apparatus will now be explained.

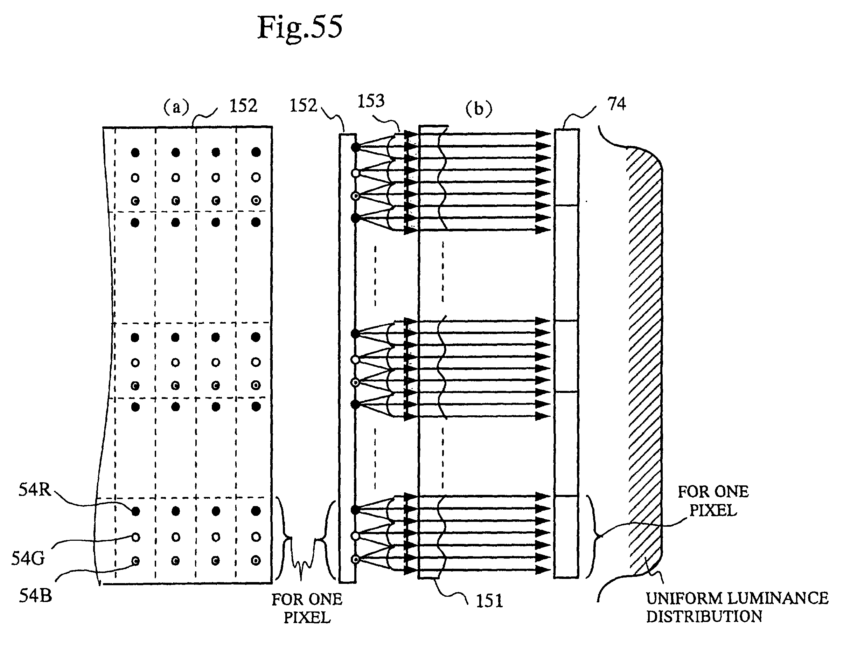

Fig. 55 shows a configuration of the direct-view type display apparatus. Fig. 55(a) illustrates the front view of an LD array 152. Plural groups, each of which is composed of semiconductor lasers 54R emitting a light for red, 54G emitting a light for green and 54B emitting a light for blue, are arranged in the LD array 152. Namely, each of the groups is composed of semiconductor lasers having different wavelengths (different colors) and each of the groups is provided for one pixel of the liquid crystal panel 74. Fig. 55(b) illustrates the side view of the direct-view type display apparatus. Beams emitted from the LD array 152 are input to an array lens 153 and converted to parallel beams. The parallel beams are further input to the modified curve surface lens 151 for realizing the luminance distribution uniformity. Beams output from the modified curve surface lens 151 are projected onto the liquid crystal panel 74. Since the projected beams have uniform luminance distribution, even images can be displayed. The LD array 152 is composed as stated in reference to Fig. 3, 6, 7, or 8. Especially, the number of components can be reduced by using the surface-emitting semiconductor laser 56 shown in Fig. 8.

Now, the operation will be stated. The three semiconductor lasers 54R, 54G, and 54B are lit in turn in time-sharing. The liquid crystal panel 74 modulates lights emitted by being synchronous with the light lit in time-sharing.

The response rate of the semiconductor laser is several ns and it is possible to switch the semiconductor laser in time-sharing. Particularly when the surface-emitting semiconductor laser is used, the modulation rate is 10 GHz (that is, the response rate is 0.1 ns, which is equal to or more than ten times as high as that of the general semiconductor laser.). The rate is high enough to control each pixel one after another. For example,

$1280 \times 1024 \times 60$ (Hz, frame rate) = $0.0786 \times 10^9$, which corresponds to 12.7ns. If this rate is shared among the colors, the rate for each color is 12.7/3 as (almost 4.2ns), which is enough to control each pixel one by one.

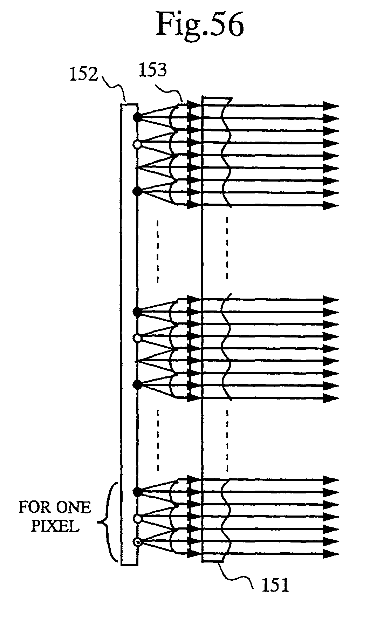

Fig. 56 shows a side view of the direct-view type display apparatus applying the surface-emitting semiconductor laser. A feature of this apparatus is that the liquid crystal panel is not used. The surface-emitting semiconductor laser is directly modulated to display an image. As set forth above, since the modulation rate of the surface-emitting semiconductor laser is fast enough to control each pixel one by one, it is possible to display images by using the method of directly modulating the surface-emitting semiconductor laser.

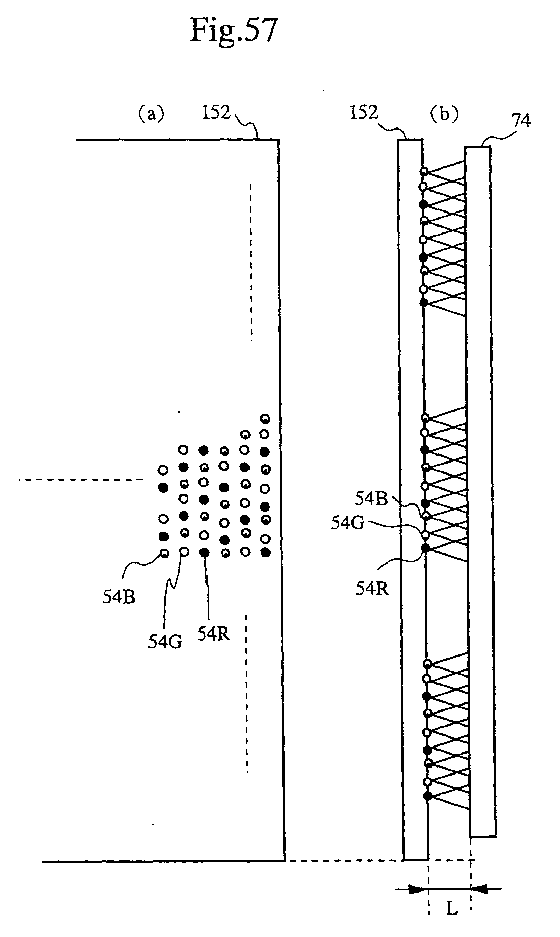

Fig. 57 shows another configuration of the direct-view type display apparatus. Fig. 57(a) shows a front view of the LD array 152. Plural groups, each of which is composed of semiconductor lasers 54R emitting a light for red, 54G emitting a light for green and 54B emitting a light for blue, are arranged in the LD array 152. In the case of Fig. 55, each of the groups is composed of semiconductor lasers having different wavelengths (different colors) and each of the groups is provided for one pixel of the liquid crystal panel 74. The semiconductor lasers 54R, 54G, and 54B of the present case do not particularly correspond to one pixel of the liquid crystal panel 74.

Fig. 57(b) illustrates a side view of the direct-view type display apparatus. Beams emitted from the LD array 152 are projected onto the liquid crystal panel 74. The beams from the LD array 152 lie upon another on the liquid crystal panel 74. If the distance L between the LD array 152 and the liquid crystal panel 74 is 5 through 10 mm, more than half the beams next to each other lie upon each other, which makes the luminance distribution of the projected beams uniform to display even images.

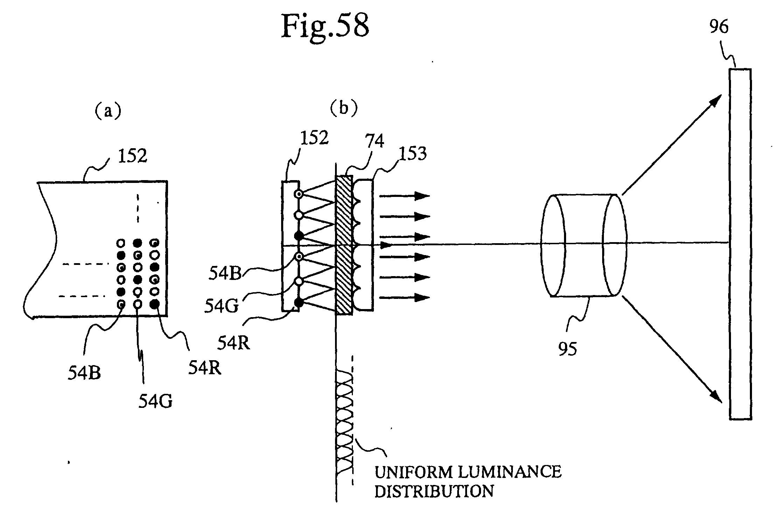

Fig. 58 shows a projection type of the time-sharing display apparatus of single plate type shown in Fig. 57. Both of the LD array 152 and the liquid crystal panel 74 are single plates, similar to those in Fig. 57, and operate in time-sharing. Beams transmitted through the liquid crystal panel 74 are converted into almost parallel beams by the array lens 153 (parallel-conversion optical system 60).

Embodiment 7.

The lens array for making the luminance of beams projected on the liquid crystal panel even and uniform will now be explained in the present embodiment. The lens array is composed of plural lens arranged like an array. Each lens in the lens array is provided to be corresponding to each of semiconductor lasers arranged like an array in the luminous device.

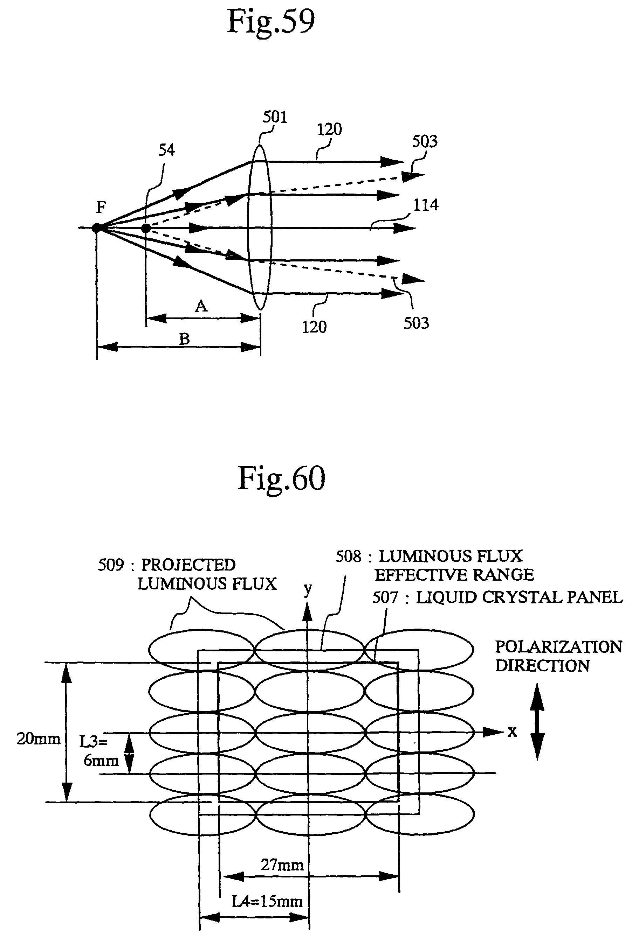

Fig. 59 shows the positional relation between the semiconductor laser 54 and a first lens 501. As shown in the figure, the semiconductor laser 54 is located slightly inside the (internal) focal point of the corresponding first lens 501, meaning closer to the lens than the internal focal point. Supposing that the focal length of the first lens 501 is B and the distance between the semiconductor laser 54 and the first lens 501 is A, it becomes to be A<B. When the semiconductor laser 54 is located at the position within the focal length B of the first lens 501 and on a optical axis 114, beams radiated from the semiconductor laser 54 become beams somewhat diverging, compared with parallel beams, via the first lens 501. In the case that the semiconductor laser 54 is located at the focal point F of the first lens 501, the first lens 501 outputs parallel beams 120, whereas if the semiconductor laser 54 is located at the position within the focal length B, the first lens 501 outputs diverging beams 503. A part of the diverging beam 503 lies on another diverging beam 503 output from another first lens 501 next to the above first lens 501. Since the beams lie on each other, the beams can have an even and uniform luminance distribution. Then, the liquid crystal panel is located at the position where beams having an even and uniform luminance distribution can be obtained. Otherwise, a second lens is located at the position, where beams having an even and uniform luminance distribution can be obtained, in order to make the diverging beams 503 parallel beams through the second lens. Then, the liquid crystal panel is located in these parallel beams. The beam having an even and uniform luminance distribution (an even luminance distribution or a uniform luminance distribution) in here does not mean the configuration where the luminance distribution is 100 % uniform, but means the beam having a luminance distribution even and uniform enough to display images.

Concretely, the above indicates that the luminance at any part is equal to or more than the value adding 1/2 of the maximum luminance to $1/e^2$ of the maximum luminance. Namely, it indicates that, at any part, "the luminance power point > half power point + $1/e^2$ power point".

The beam pattern of the present embodiment will be explained with reference to Fig. 60. In the case of Fig. 60, the output angle is 8.5° × 22° (angle of half power point) and a semiconductor laser of 5.6 mm outside case size is used. The size of the liquid crystal panel onto which the beams are projected is 1. 3 inches (the length 20 mm, the width 26.5 mm, the diagonal 33 mm). The luminous flux on the liquid crystal panel is supposed to be length/width = sin22 °/sin8.5° ≒ 2.5 and the interval between the elements is supposed to be 6mm (the minimum value). As shown in Fig. 60, the semiconductor lasers are arranged in the length of 5 rows (6 mm interval) and the width of 3 rows (15 mm interval). The luminous flux on the liquid crystal panel is an ellipse luminous flux of 6mm × 15mm. In Fig. 60, a luminous flux effective range 508 is located at the outside of the outer frame of the liquid crystal panel 507.

The luminous flux effective range 508 is defined by lining the center of each of the projected luminous fluxes 509 arranged on the outer circumference.

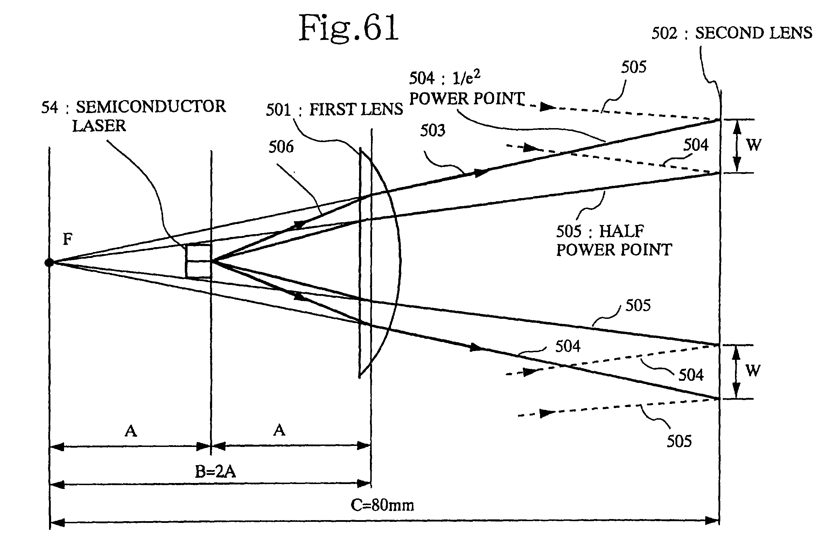

A concrete optical system is shown with reference to Fig. 61. The semiconductor laser 54 is located at 1/2 of the focal length of the first lens 501, and B = 2A . An output luminous flux 506 output from the semiconductor laser 54 is converted into the diverging beam 503 by the first lena 501. The range W, between a half power point 505 and a $1/e^2$ power point 504, on a second lens 502 is the place where the diverging beams 503, output from the neighboring semiconductor lasers 54 and neighboring first lenses 501, lie upon each other. The ranges W lie on each other at the second lens 502, so that an even luminous flux and a uniform luminance distribution can be obtained.

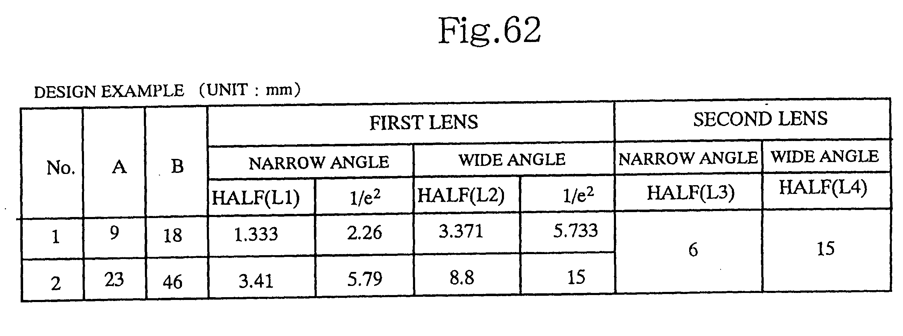

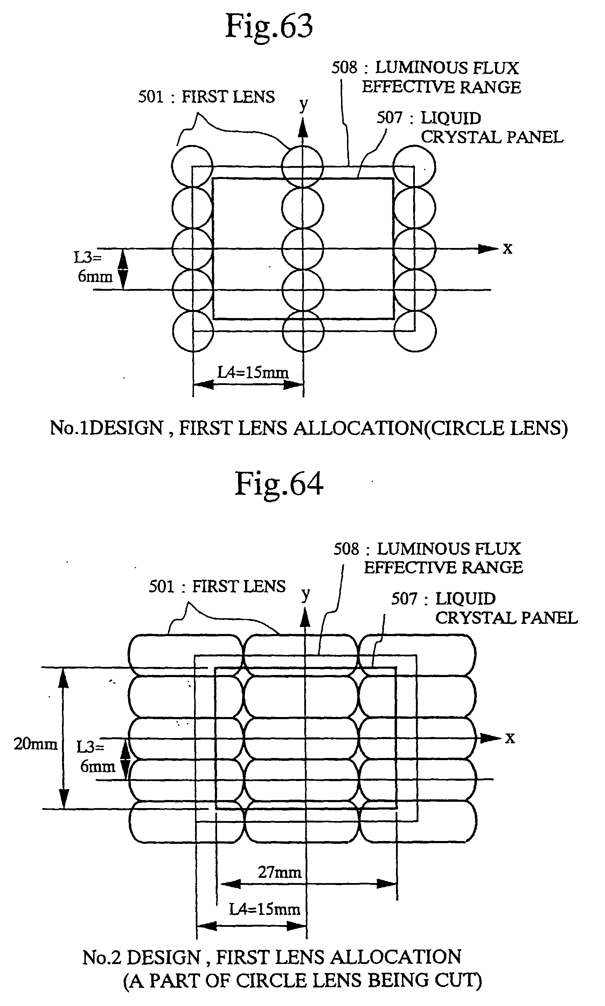

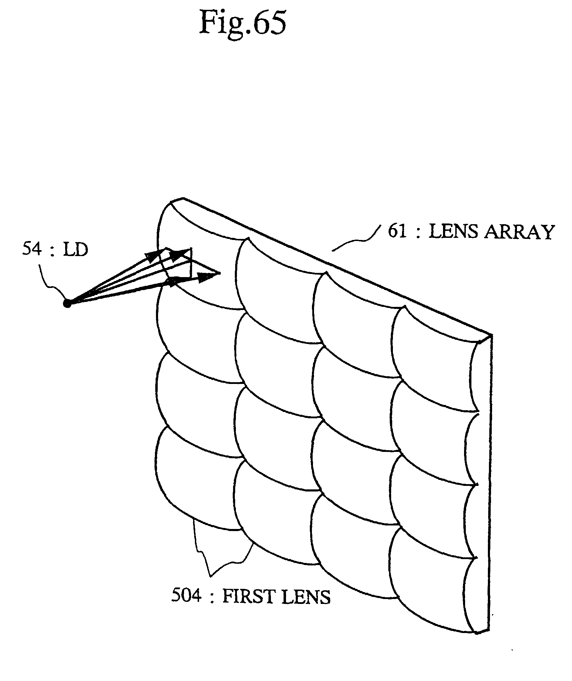

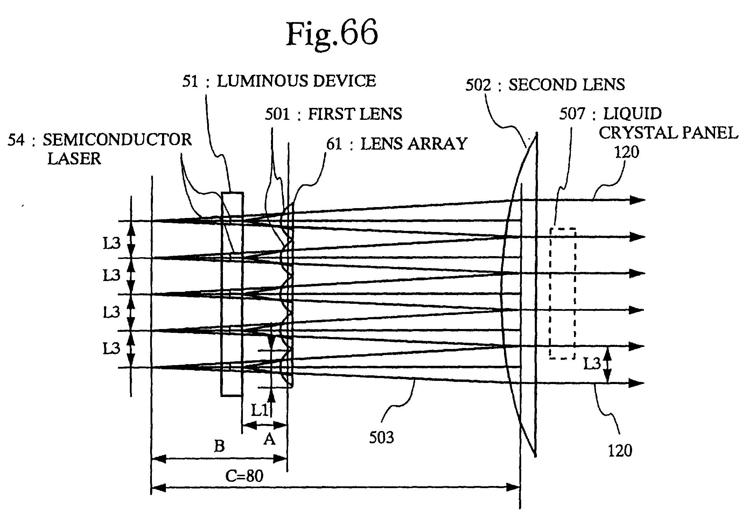

Fig. 62 shows a concrete design example of the optical system shown in Fig. 61. Two design examples of No. 1 and No. 2 are shown in Fig. 62. Fig. 63 shows a relation between the arrangement of the first lens 501 and the liquid crystal panel 507, of the No. 1 design example. Fig. 64 shows a relation between the arrangement of the first lens 501 and the liquid crystal panel 507, of the No. 2 design example. Fig. 65 shows a perspective view of the lens array 61 of the first lens 501 shown in Fig. 64. When the semiconductor laser 54 is located closer to the first lens 501 in Fig. 61, that is the No. 1 design example case, the first lens 501 is circle as shown in Fig. 63. When the semiconductor laser 54 is located a little farther from the first lens 501, that is the No. 2 design example case, the first lens 501 is rectangle, like a shape made by cutting the top and bottom sides of a big circle lens, as shown in Fig. 64. Fig. 66 shows a side view of the irradiation optical system in the design example of No. 1 or No. 2. Fig. 66 shows a narrow angle (small divergence angle) case.

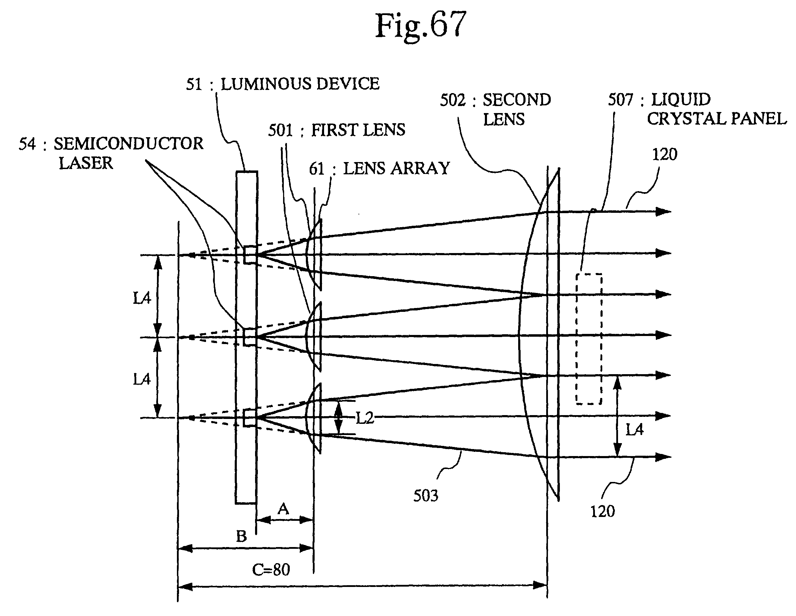

Fig. 67 shows a flat view of the irradiation optical system in the design example of No. 1 or No. 2. Fig. 67 shows a wide angle (large divergence angle) case. The half power point 505 is indicated in the solid line in Figs. 66 and 67. The line of the $1/e^2$ power point 504 is not shown in Figs. 66 and 67. Each of the beams emitted from the semiconductor lasers 54 is input to each first lens 501 of the lens array 61 and becomes the diverging beam 503, as shown in Figs. 66 and 67. The diverging beams 503 are input into the second lens 502. The second lens 502 is composed of a large convex lens. It is also acceptable to directly allocate the liquid crystal panel 507 instead of the second lens 502. In the case of the second lens 502 being provided, since the diverging beams 503 are converted to the parallel beams 120 by the second lens 502 and projected on the liquid crystal panel 507, an image having further high luminance can be obtained.

In the optical system having the configuration as stated above, the luminance distribution can be varied by changing the distance between the first lens 501 and the semiconductor laser 54. When the semiconductor laser 54 is close to the first lens 501, it becomes dark since the beams to be utilized are lessened because of the divergence angle of the diverging beams 503 becoming large. On the other hand, the farther the semiconductor laser 54 is located from the first lens 501, meaning the closer the semiconductor laser 54 is located to the focal point, the more similar the diverging beams 503 become to the parallel beams 120, consequently the luminance is enhanced. Accordingly, it is possible to adjust the luminance to be the best, by moving the location of the first lens 501 in the direction of parallel to the optical axis or moving the location of the semiconductor laser 54 in the direction of parallel to the optical axis. In order to adjust the distance concerning the above, any configuration can be acceptable as long as the function of moving the LD array 51 or the lens array 61 along the optical axis is provided in Figs. 66 and 67.

The lens array 61, stated in the present Embodiment, directly inputs beams output from the luminous device and has a function of converting at least one of the section shape and the size of the beams, as a beam-conversion optical system. The second lens 502 has a function of inputting beams output from the beam-conversion optical system and converting the beams to those approximately parallel, as a parallel-conversion optical system.

Accordingly, the image display apparatus in which the luminous device, the beam-conversion optical system, the optical switch and the display optical system are provided has been explained: the luminous device wherein plural semiconductor lasers are arranged in two-dimensional array, the beam-conversion optical system which directly inputs beams output from the luminous device and converts at least one of the section shape and the size of the beams, the optical switch which inputs beams output from the beam-conversion optical system and modulates the beams, and the display optical system which inputs beams modulated by the optical switch and displays images. Further, the image display apparatus includes, between the beam-conversion optical system and the optical switch, a parallel-conversion optical system for inputting and converting beams output from the beam-conversion optical system to beams approximately parallel.

Embodiment 8.

An optical system for making the luminance even will be explained in the present embodiment.

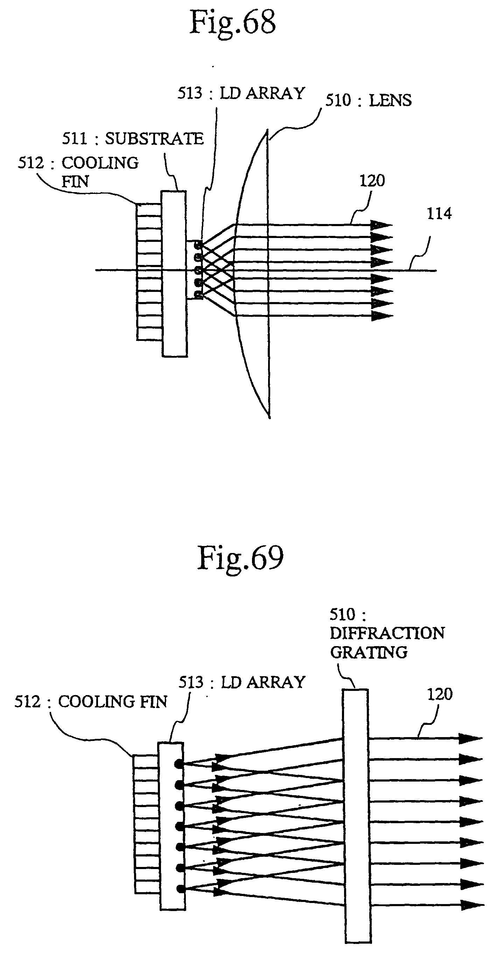

In Fig. 68, an integration LD array 513, being an example of integration luminous device, is an integrated circuit of integrated one chip. The center of the integration LD array 513 is located at the focal point of a lens 510. Since the integration LD array 513 is integrated and has a small area, it is possible to obtain parallel beams 120 having even luminance, by using one lens 510 relatively large. Namely, the integration LD array 513 can be regarded as a point light source or a micro light source. As shown in Fig. 68, diverging output beams diverged from the integration LD array 513 lie on each other to form beams having an even luminance distribution. The output beams are converted into beams approximately parallel by the lens 510. It is also acceptable to use a surface-emitting semiconductor laser as the integration luminous device, instead of the integration LD array 513. The integration LD array 513 being integrated or the surface-emitting semiconductor laser is regarded as the micro light source. In such a micro light source, the heat divergence is extremely important. Then, it is preferable that the micro light source is fixedly attached on a substrate (metal plate etc.) having good heat conduction, and a cooling fin 512 is provided, in order to effectively diverge the heat.

Fig. 69 shows an optical system for making the luminance even by using a diffraction grating 515. The diffraction grating is a transmission type phase grating made by forming periodical uneven ditches on a transparent parallel-plate. If a parallel plane wave having uniform intensity is input into the transmission type phase grating, beams divided into plural by the diffracting phenomenon are output from the transmission type phase grating, which shows a diffraction pattern formed by aggregating beams having a peak at the center of it and being symmetry with respect to a point.

Fig. 69 shows an optical system wherein the inverse phenomenon against the above is utilized. In this optical system, output beams from each of the point light sources (LD) are converted into parallel beams having even luminance distribution, by transmitting the diffraction grating.

Embodiment 9.

A luminous element utilizing superradiation and a luminous device utilizing the luminous element will now be explained in the present embodiment.

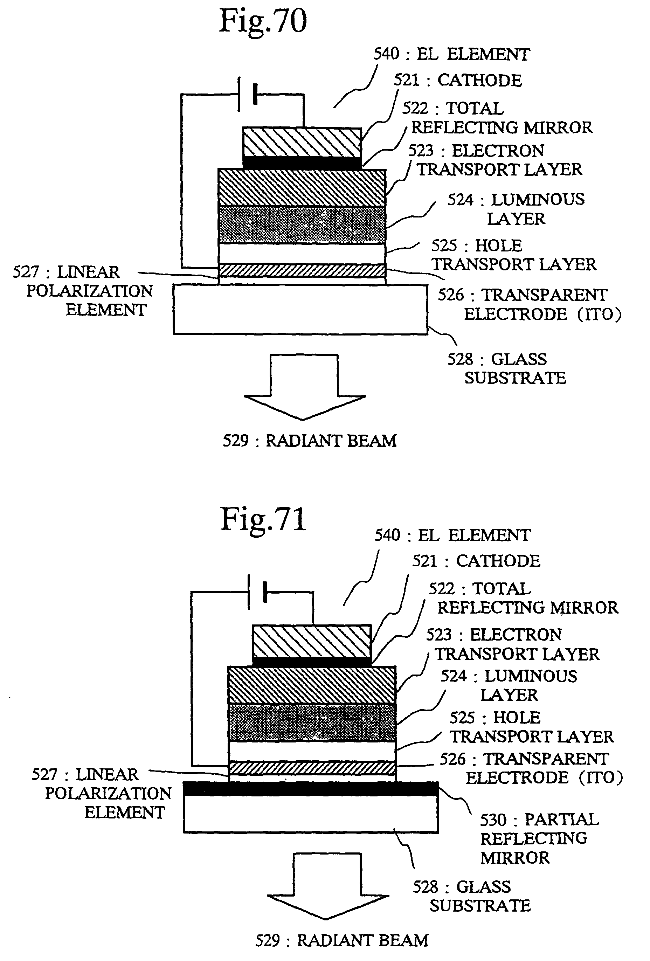

Fig. 70 shows a configuration of an organic EL (electro-luminescent) element emitting by utilizing the superradiation. The EL element 540 of Fig. 70 is composed by layering a cathode 521, a total reflecting mirror 522, an electron transport layer 523, a luminous layer 524, a hole transport layer 525, a transparent electrode (ITO) 526, a linear polarization element 527, and a glass substrate 528. When a voltage is applied to the cathode 521 and the transparent electrode 526 (ITO), a radiant beam 529 is output from the glass substrate 528.

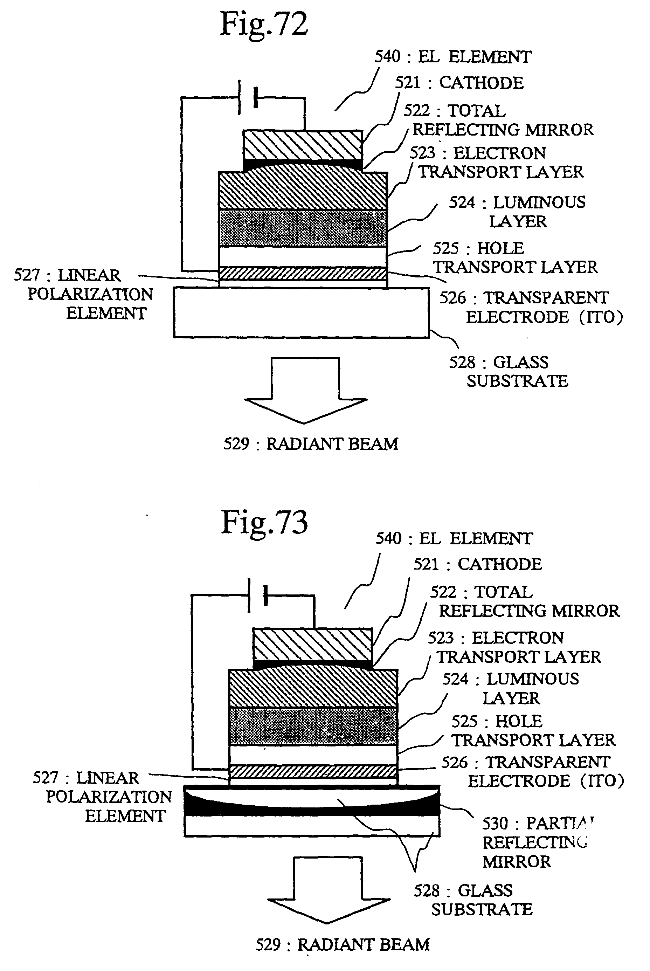

As shown in Fig. 70, the metal total reflecting mirror is provided at the bottom of the cathode so as to easily emit superradiation, and the linear polarization element is provided to linearly polarize the radiant beams. The total reflecting mirror is formed with a thin metal film and the linear polarization element is formed with a thin transparent film. The emitted output beams are very strong beams similar to linearly polarized beams having directivity by the induced emission effect. Fig. 71 shows an optical resonator configuration in which a partial reflecting mirror is provided at the bottom of the linear polarization element in order to further strengthen the beams. Consequently, strong linearly polarized beams can be obtained even if the beams are not so strong as laser oscillation. The partial reflecting mirror is made by a transparent dielectric multi-layered film composed of $S_iO_2$ film (low refractive index) and $T_iO_2$ film (high refractive index) being provided by turns. In order to further enhance the directivity, as shown in Figs. 72 and 73, a spherical mirror having curvature can be used for the total reflecting mirror and the partial reflecting mirror.

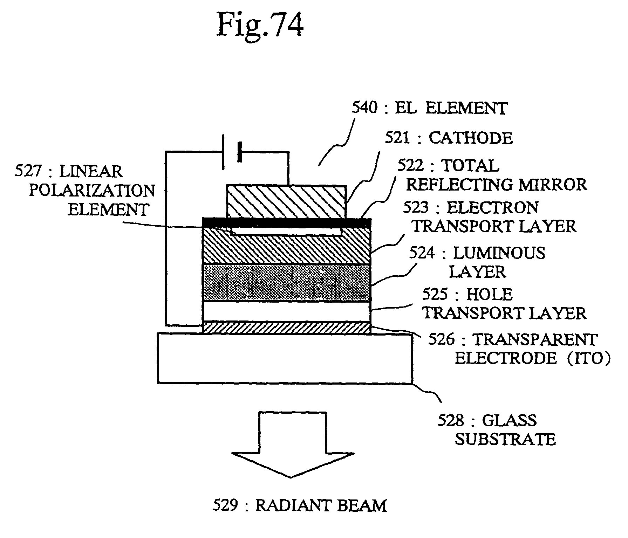

It is also acceptable to provide the linear polarization element 527 between the total reflecting mirror 522 and the electron transport layer 523. In this case, since the linear polarization element 527 is the dielectric (insulation), the configuration of the metal total reflecting mirror 522 being attached to the electron transport layer 523 is needed. The total reflecting mirror 522 should be formed only on the side where the linear polarization element 527 is attached to the electron transport layer 523. Comparing the configurations of Figs. 70 and 74, that of Fig. 74 is preferable because it is easier to obtain the radiant beams 529 having been linearly polarized in the configuration of Fig. 74.

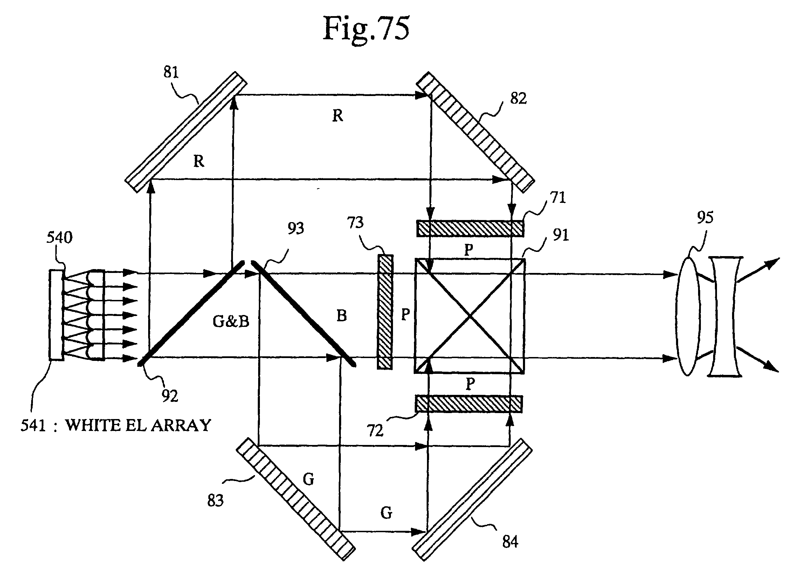

Fig. 75 shows a projection type projector applying a white EL array 541 wherein the EL elements 540 are arrayed. The white EL array 541 are made by arraying the EL elements outputting white. As the operation of the projection type projector utilizing beams output from the white EL array 541 is the same as that stated with reference to Fig. 15, the explanation is omitted in here.

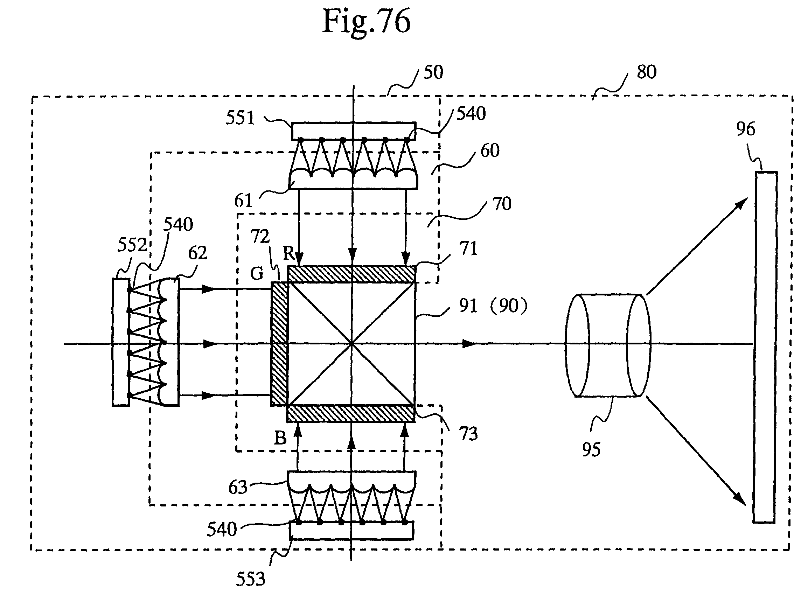

Fig. 76 shows a projection type projector applying EL arrays 551, 552, and 553. The operation of this is the same as that stated with reference to Fig. 1. Though not shown, it is also acceptable to provide the EL array for the configuration of Fig. 9 or Fig. 10.

When the linear polarization element 527 is not used for the EL element, the polarization-conversion optical system is needed. Then, for the optical system in this case, it is acceptable to employ a configuration of the polarization-conversion system 85 shown in Fig. 15. Namely, the EL element 540 can be used instead of the lamp light source shown in the polarization-conversion system 85 of Fig. 15.

The projection type projector can be manufactured by performing direct modulation with using the EL element 540. Therefore, by dint of arraying the EL elements 540 and performing the direct modulation with using each EL element 540, the liquid crystal panel becomes unnecessary. Besides, since the liquid crystal panel is not used, the linear polarization element 527 is not necessary. A luminous device in which the EL elements 540 are arrayed can be effectively utilized in the projection type projector, because beams having high luminance and enhanced directivity are output by the superradiation emitted based on that the total reflecting mirror 522 and the partial reflecting mirror 530 are provided in the EL elements 540. The optical system performing a direct modulation by using the EL elements 540 corresponds to the one excluding the liquid crystal panels 71, 72 and 73 shown in Figs. 1, 9, and 10. Namely, it is enough just to combine the three colors and project the combined one.

Accordingly, the image display apparatus can be composed of a display optical system where the arrayed EL elements 540 radiating beams based on superradiation are regarded as light sources, the EL elements 540 are directly modulated, meaning that the light sources are modulated, and output modulated beams are displayed.

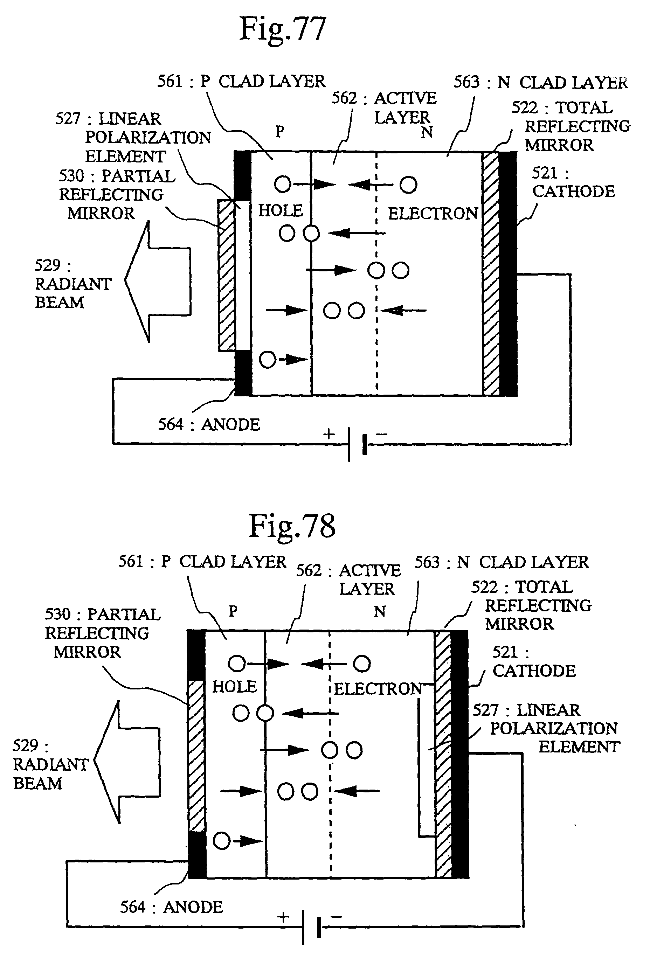

Fig. 77 shows an LED (light emitting diode) element (luminous diode element) 560. The LED element 560 is composed of the cathode 521, the total reflecting mirror 522, an N clad layer 563, an active layer 562, a P clad layer 561, the linear polarization element 527, the partial reflecting mirror 530 and an anode 564. When a voltage is applied between the cathode 521 and the anode 564, the radiant beam 529 is output. The LED element 560 is a light emitting diode.

When a forward voltage is applied by a crystal having PN junction, electrons in the N clad layer and holes in the P clad layer are moved to the active layer (PN junction). Consequently, light is generated when the electrons and the holes are reconnected. Namely, in the case that the free electrons come into the junction state, some energy is emitted to be radiated light. By putting the total reflecting mirror 522 or the partial reflecting mirror 530 at each side of the P and N clad layer, only beams orthogonally going with respect to the mirror are strengthened (induced emission) to become strong beams having directivity (superradiation). It is acceptable to use only total reflecting mirror. A superradiation beam of linear polarization can be obtained by putting the linear polarization element between the two mirrors.

Fig. 78 shows the case of the linear polarization element 527 being provided between the total reflecting mirror 522 and the N clad layer 563. Comparing with Fig. 77, it is easier to obtain linear polarization in the configuration of Fig. 78, consequently that of Fig. 78 is more desirable.

The luminous device applying LED elements 560 in the array state can have the same configuration as the one applying EL elements 540 in the array. For instance, it is possible to compose a projection type projector having the configuration of Fig. 75 or 76. It is also possible to compose a projection type projector by performing a direct modulation, without using the liquid crystal panel.

Embodiment 10.

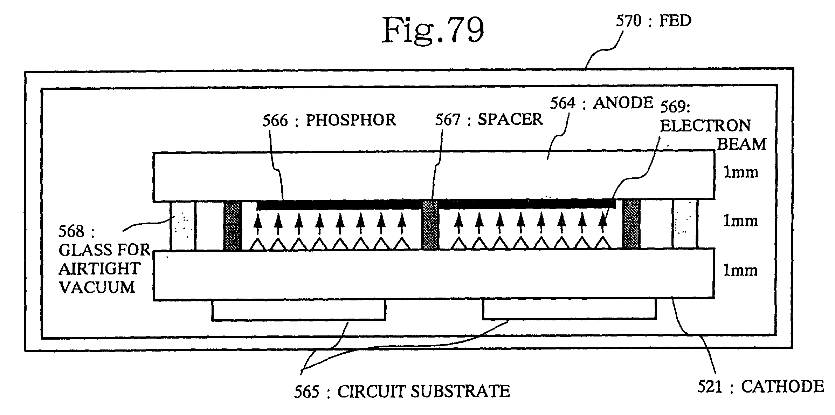

Fig. 79 shows an FED (Field Emission Display) 570. The FED 570 is composed of a circuit substrate 565, the cathode 521, the anode 564, a spacer 567, a phosphor 566 and a glass for airtight vacuum 568. Electron beams 569 are emitted from the cathode 521 to make the phosphor 566 luminous, by the control circuit provided on the circuit substrate 565. In order to prevent the cathode 521 from deteriorating, the electron beams 569 are emitted in the vacuum from the cathode 521 to the anode 564. The emission theory of making the phosphor 566 luminous by projecting the electron beam 569 onto it is the same as that of CRT (Cathode Ray Tube). In the ease of the CRT, however, it is necessary to operate the electron beams up and down, and right and left. In this FED 570 case, on-and-off of each pixel is executed by performing a line-by-line addressing so as to make on-and-off of the electron beam 569 per pixel.

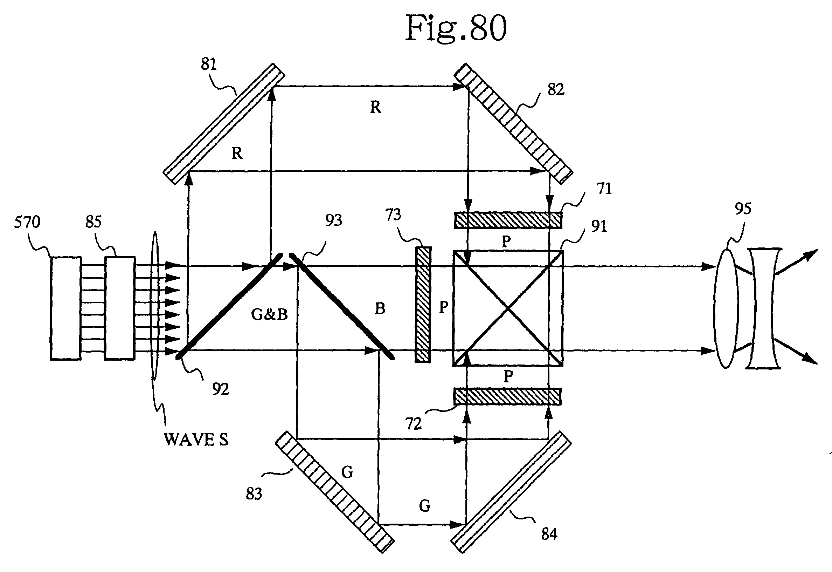

Fig. 80 shows a configuration of the projection type projector applying the FED 570 as a luminous device. Each pixel of the FED 570 is regarded as a light source, and the FED 570 is regarded as a luminous device where the light sources are arranged in the array state. Output beams from the FED 570 are converted into linearly polarized beams by the polarization-conversion system 85. Then, the beams are modulated by the red-transmission type liquid crystal panel 71, the green-transmission type liquid crystal panel 72, and the blue-transmission type liquid crystal panel 73, so as to create an image. Fig. 80 shows the projection type projector, and it is also acceptable to have a direct-view type image display apparatus.

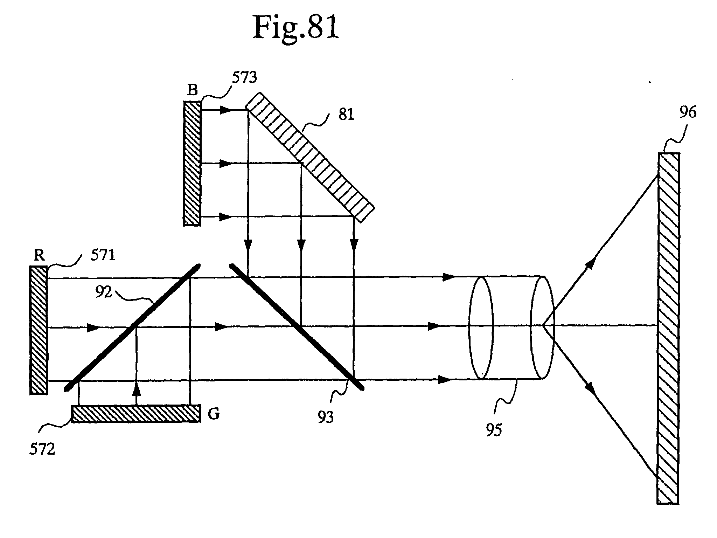

Fig. 81 shows the case that each of an FED for red 571, FED for green 572, and FED for blue 573 directly modulates. In the case of directly modulating as this, the polarization-conversion system is not necessary. Besides, the liquid crystal panel and the color filter are also unnecessary. Namely, in Fig. 81 case, it is enough just to combine the three colors in order to create an image.

Embodiment 11.

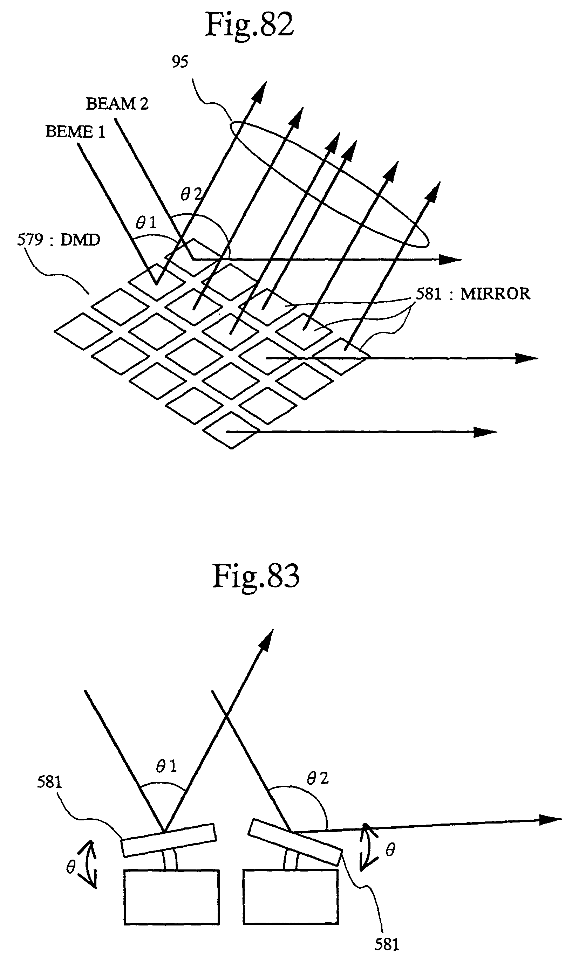

In the present embodiment, the case of a DLP (digital light processing) applying a DMD (digital micro-mirror device) will be explained. In the DLP system currently used, a xenon lamp or a UHP (ultra high precision) lamp is used as the light source. Output beams from the lamp are projected on a DMD 579 as shown in Fig. 82. The DMD 579 is composed of plural mirrors 581 arranged in the array state. As shown in Fig. 83, the mirror 581 can be moved by the angle $\theta$ to be controlled. In Fig. 82, the beam 2 is not input to the projection lens 95, while the beam 1 is input to the projection lens 95. Whether being input to the projection lens or not depends upon the angle $\theta$ of the mirror 581. The angle is defined by the control of a static random access memory.

As stated above, the DMD 579 can control on-and-off by utilizing reflections of the mirrors 581. Parallel beams are the best for the beams projected on the DMD 579. Therefore, in order to supply the parallel beams, it is the most appropriate to utilize laser beams output form the semiconductor laser. When the laser beam is used, the light loss can be little, consequently the light-utilization rate is enhanced.

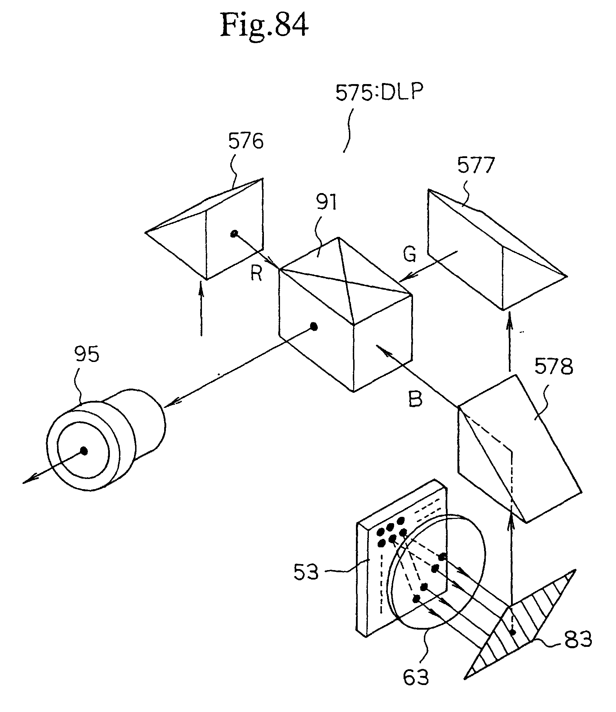

Fig. 84 shows a configuration of DLP 575 applying a DMD 576 for red, a DMD 577 for green, and a DMD 578 for blue. Beams output from the LD array 53 and converted to parallel beams through the lens array 63 are input into the DMD 578 for blue. The DMD 578 for blue performs on-and-off of the beams by rotating the mirrors 581 with using the static random access memory. Similarly, though not shown, parallel beams emitted from the LD array 53 through the lens array 63 are input to the DMD 576 for red or the DMD 577 for green to perform the same operation as the DMD 578 for blue. Then, the three color beams are combined by the cross dichroic prism 91 to create an image.

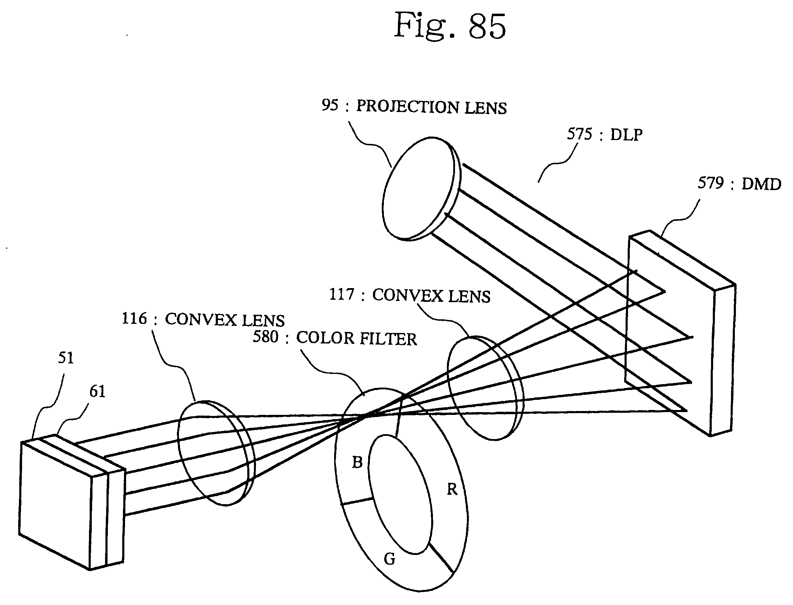

Fig. 85 shows the DLP 575 having one luminous device. The LD array 51 in which white LDs emitting white laser beams are arranged in the array state corresponds to the above luminous device. Beams emitted from the LD array 51 are converted into parallel beams by the lens array 61. The parallel beams are projected onto a color filter 580 via the convex lens 116. The color filter 580 emits three color beams in time-sharing by being rotated. Then, the beams transmitted through the convex lens 117 are projected onto the DMD 579. The projected three color beams are modulated in time-sharing at the DMD 579, and then only necessary beams are reflected to the projection lens 95. Unnecessary beams are not input into the projection lens 95. As set forth above, the luminous device applying the semiconductor lasers arranged in the array state is very effective for the DMD.

Embodiment 12.

In the above Embodiments 1 through 11, the projection type projector case or the direct-view display apparatus case has been described as an example of the image display apparatus. As a light source applied in the luminous device, the case of semiconductor laser, electro-luminescent element, luminous diode element, FED, micro lamp, or linear polarization source has been explained.

As a modulation element, the case of transmission type liquid crystal panel, reflection type liquid crystal panel, PDLC, or DMD has been described.

As for a beam modulation, the case of modulating by using the liquid crystal panel, directly modulating by using the electro luminescent element or the luminous diode element, or modulating by using the FED or DMD has been explained.

As an optical system for making the luminance even (beam-conversion optical system), the case of using a lens array, a modified curve surface lens, the combination of an integrated light source and a lens, or the diffraction grating has been described.

Besides, the case of the polarization conversion system being necessary, or unnecessary has been explained.

Combinations made by combining ones in the above has been described in the Embodiments 1 through 10. Of course, other combinations in addition to the above Embodiments are also acceptable. Besides, it is supposed that all the combinations having possibility in the theory have been disclosed in this specification in addition to the above Embodiments, though they are not shown in the drawings or not explained. As it is impossible to show drawings for all the combinations or to explain for all the combinations, only preferable embodiments have been described. The invention of the present application indicates not only the combinations drawn in the figures or having been explained but also the combinations not drawn or not explained.

For instance, as concrete examples of the combinations, the one applying the EL as a light source will be stated as follows: The following concrete examples can also be applied for the LED.

*Projection type display apparatus

EL direct modulation system (LCD not being used)

(1) white EL light source • projection type of direct modulation system
(2) three color EL light source • projection type of direct modulation system (excluding LCD from Figs. 1, 9, and 10)
(3) superradiation white EL light source • projection type of direct modulation system (lighter than (1))
(4) superradiation three color EL light source • projection type of direct modulation system (excluding LCD from Figs. 1, 9 and 10, and being lighter than (2))

LCD modulation system (EL number < LCD pixel number can be possible)

(1) white EL light source • projection type of LCD modulation system (Fig. 75)
(2) three color EL light source • projection type of LCD modulation system (the same as Fig. 76, 1, 9 or 10)
(3) superradiation white EL light source • projection type of LCD modulation system (Fig. 75)
(4) superradiation three color EL light source • projection type of LCD modulation system (the same as Fig. 76, 1, 9 or 10)

*Direct-view type display apparatus

EL direct modulation system (LCD not being used)

(1) white EL light source • direct-view type of direct modulation system (color filter and such being necessary)
(2) three color EL light source • direct-view type of direct modulation system
(3) superradiation white EL light source • direct-view type of direct modulation system (lighter than (1), but color filter and such being necessary)
(4) superradiation three color EL light source • direct-view type of direct modulation system (Fig. 56, the same as surface emitting LD, time-sharing being possible)

LCD modulation system (EL number < LCD pixel number can be possible)

(1) white EL light source • direct-view type of LCD modulation system (effective in EL back light system)
(2) three color EL light source • direct-view type of LCD modulation system (the same as Fig. 55 or Fig. 56, providing a polarization-conversion optical system for three colors being desirable, time-sharing being possible)
(3) superradiation white EL light source • direct-view type of LCD modulation system (color filter being necessary)
(4) superradiation three color EL light source • direct-view type of LCD modulation system (the same as Fig. 55: modified curve lens being used, the same as Fig. 57: modified curve lens not being used, lighter than (2), time-sharing being possible)

Industrial Applicability

As set forth the above, according to the present invention, there is an effect that the polarization-conversion optical system is not necessary because the linearly polarized beam is utilized.
According to the present invention, unnecessary heat radiation can be lessened and the heat radiation system can be omitted, because the light-utilization rate is enhanced.
According to the present invention, it is easy to generate parallel beams.
According to the present invention, down-sizing and low-cost can be realized because the optical system is simplified.
According to the present invention, high luminance of image and quality enhancement of image can be realized.

**Claims**

1.  An image display apparatus comprising:

(a) a luminous device composed of two-dimensionally arrayed plural semiconductor lasers;

(b) a parallel-conversion optical system for directly inputting beams output from the luminous device and converting the beams into substantially parallel beams;

(c) an optical switch for inputting beams output from the parallel-conversion optical system and modulating the beams; and

(d) a display optical system for inputting beams modulated by the optical switch in order to display an image.

2. The image display apparatus of claim 1, further comprising a beam-conversion optical system between the parallel-conversion optical system and the optical switch, for converting a section size of the beams into a light-utilization size for the optical switch.

3. An image display apparatus comprising:

    (a) a luminous device composed of two-dimensionally arrayed plural semiconductor lasers;

    (b) a beam-conversion optical system for directly inputting beams output from the luminous device and converting at least one of a beam section shape and a beam section size of the beams;

    (c) an optical switch for inputting beams output from the beam-conversion optical system and modulating the beams; and

    (d) a display optical system for inputting beams modulated by the optical switch in order to display an image.

4. The image display apparatus of claim 3, further comprising a parallel-conversion optical system between the beam-conversion optical system and the optical switch, for inputting the beams output from the beam-conversion optical system and converting the beams into substantially parallel beams.

5. The image display apparatus of claim 1 or 3, wherein each of the two-dimensionally arrayed plural semiconductor lasers is one of a semiconductor laser outputting a multi-mode laser beam and a semiconductor laser outputting a laser beam of wide spectrum.

6. The image display apparatus of claim 1 or 3, wherein the luminous device includes arrayed integrated semiconductor lasers.

7. The image display apparatus of claim 1 or 3, wherein the luminous device includes a surface-emitting semiconductor laser.

8. An image display apparatus comprising:

    (a) a luminous device composed of arrayed plural discharge lamps;

    (b) an optical switch for inputting beams output from the luminous device and modulating the beams;

    (c) a parallel-conversion optical system for inputting one of the beams output from the luminous device and beams modulated by the optical switch, and converting input beams into substantially parallel beams; and

    (d) a display optical system for inputting one of beams output from the parallel-conversion optical system and the beams modulated by the optical switch in order to display an image.

9. An image display apparatus comprising:

    (a) a luminous device composed of arrayed plural electro-luminescent elements;

    (b) an optical switch for inputting beams output from the luminous device and modulating the beams;

    (c) a parallel-conversion optical system for inputting one of the beams output from the luminous device and beams modulated by the optical switch, and converting input beams into substantially parallel beams; and

    (d) a display optical system for inputting one of beams output from the parallel-conversion optical system and the beams modulated by the optical switch in order to display an image.

10. The image display apparatus of claim 1, 3, or 9, wherein the optical switch is a liquid crystal panel.

11. The image display apparatus of claim 1, 3, or 9, wherein the optical switch is a reflection type liquid crystal panel.

12. The image display apparatus of claim 1, 3, or 9, wherein the luminous device has plural light sources, an array shape of which is similar to a light-utilizing shape of the optical switch.

13. The image display apparatus of claim 8, further comprising a controller for controlling each of the plural light sources.

14. The image display apparatus of claim 8, wherein the luminous device is an aggregation of light sources having different spectral distributions.

15. The image display apparatus of claim 8, wherein the luminous device is an aggregation of discharge lamps, a gap length of each of which is less than 4mm, outputting parallel beam luminous flux of lumen equal to and more than several hundred, and the parallel-conversion optical system is an aggregation of reflectors making beams output from each of the discharge lamps be parallel beams.

16. The image display apparatus of claim 8, wherein the luminous device is able to change at least one of a beam section shape and a beam section size.

17. The image display apparatus of claim 8, wherein the luminous device is able to change a light source type.

18. The image display apparatus of claim 8, wherein the luminous device is able to change an array shape of light source.

19. The image display apparatus of claim 8, wherein the luminous device allocates light sources having different sizes.

20. The image display apparatus of claim 8, wherein the luminous device includes a lamp in which a part of a discharge tube is used as a reflector.

21. An image display apparatus comprising:

    (a) a light source for emitting beams based on superradiation;

    (b) an optical switch for inputting substantially linearly polarized beams output from the light source and modulating the substantially linearly polarized beams; and

    (c) a display optical system for displaying beams modulated by the optical switch.

22. The image display apparatus of claim 21, wherein the image display apparatus is a projection type image display apparatus and the light source is used for the projection type image display apparatus.

23. The image display apparatus of claim 22, further comprising:

    (a) a light source for color image;

    (b) a light source for luminance image;

    (c) an optical switch for color image for creating a color image by using the light source for color image;

    (d) an optical switch for luminance image for creating a luminance image by using the light source for luminance image; and

    (e) a combining optical system for combining the color image created by the optical switch for color image with the luminance image created by the optical switch for luminance image in order to create a combination image;
    wherein the light source for emitting beams based on superradiation is used for at least one of the light source for color image and the light source for luminance image.

24. The luminous element of claim 21, wherein the light source is used for a direct-view type image display apparatus.

25. The luminous element of claim 21, wherein the light source includes an electro-luminescent element.

26. The luminous element of claim 21, wherein the light source includes a light emitting diode element.

27. An image display apparatus comprising:

    (a) a light source for emitting beams based on superradiation; and

    (b) a display optical system for displaying beams modulated and output at the light source.

28. The image display apparatus of claim 27, wherein the image display-apparatus is a projection type image display apparatus and the light source is used for the projection type image display apparatus.

29. The image display apparatus of claim 28, further comprising:

    (a) a light source for color image;

    (b) a light source for luminance image;

    (c) an optical switch for color image for creating a color image by using the light source for color image;

    (d) an optical switch for luminance image for creating a luminance image by using the light source for luminance image; and

    (e) a combining optical system for combining the color image created by the optical switch for color image with the luminance image created by the optical switch for luminance image in order to create a combination image;
    wherein the light source for emitting beams based on superradiation is used for at least one of the light source for color image and the light source for luminance image.

30. The luminous element of claim 27, wherein the light source is used for a direct-view type image display apparatus.

31. The luminous element of claim 27, wherein the light source includes an electro-luminescent element.

32. The luminous element of claim 27, wherein the light source includes a light emitting diode element.

33. An image display apparatus comprising:

    (a) a light source for color image;

    (b) a light source for luminance image;

    (c) an optical switch for color image for creating a color image by using the light source for color image;

    (d) an optical switch for luminance image for creating a luminance image by using the light source for luminance image; and

    (e) a combining optical system for combining the color image created by the optical switch for color image with the luminance image created by the optical switch for luminance image in order to create a combination image.

34. An image display apparatus comprising:

    (a) a luminous device composed of arrayed light sources outputting different wavelength beams in time-sharing.

35. An image display apparatus comprising:

    (a) a luminous device composed of arrayed light sources outputting different wavelength beams in time-sharing, and

    (b) an optical switch for inputting the different wavelength beams output from each of the arrayed light sources of the luminous device, and modulating input different wavelength beams in time-sharing.

36. The image display apparatus of claim 34 or 35, wherein the luminous device is composed of a plurality of luminous devices in which a plurality of semiconductor lasers outputting same wavelength beams is arrayed, and each of the plurality of luminous devices operates in time-sharing in order to output a beam in time-sharing.

37. The image display apparatus of claim 34 or 35, wherein the luminous device is composed of arrayed semiconductor laser groups, each of which is made of semiconductor lasers of plural kinds outputting different wavelength beams.

38. The image display apparatus of claim 37, wherein each of the semiconductor lasers of plural kinds operates in time-sharing in order to output a beam in time-sharing.

39. The image display apparatus of claim 37, wherein the optical switch is a liquid crystal panel, and each of the arrayed semiconductor laser groups is provided to be corresponding to each pixel of the liquid crystal panel.

40. The image display apparatus of claim 37, wherein the luminous device includes a surface-emitting semiconductor laser composed of arrayed semiconductor laser groups, each of which is made of semiconductor lasers of plural kinds outputting different wavelength beams.

41. The image display apparatus of claim 1, 34 or 35, further comprising a beam-conversion optical system for making a luminance distribution of beams output from the luminous device to be uniform.

42. The image display apparatus of claim 41, wherein the beam-conversion optical system includes an analog phase control element for controlling a beam phase.

43. The image display apparatus of claim 42, wherein the analog phase control element is a modified curve surface lens.

44. The image display apparatus of claim 1, wherein the parallel-conversion optical system includes a lens array composed of arrayed plural lenses corresponding to the arrayed plural light sources of the luminous device.

45. The image display apparatus of claim 44, wherein each of the light sources is located at a position within a focal point of each of the arrayed plural lenses in order to make each of the arrayed plural lenses output beams diverging compared with parallel beams, so that circumference of each of the beams output from the each of the arrayed plural lenses can be overlapped each other.

46. The image display apparatus of claim 45, wherein the parallel-conversion optical system includes a single lens for inputting the diverging beams, whose circumference is overlapped, output from the each of the arrayed plural lenses, and outputting parallel beams.

**47.** The image display apparatus of claim 44, wherein at least either of the arrayed plural light sources and the arrayed plural lenses are installed to be movable in order to change a distance between the arrayed plural light sources and the arrayed plural lenses, so that a beam luminance distribution can be changed.

**48.** The image display apparatus of claim 1, wherein the luminous device is an integrated luminous device composed of integrated plural light sources, and the parallel-conversion optical system includes a lens located in order to make a center part of the integrated luminous device be a focal point of the lens.

**49.** The image display apparatus of claim 1, wherein the parallel-conversion optical system includes a transmission type diffraction grating.

**50.** A luminous element comprising a linear polarization element for substantially linearly polarizing an emission light.

**51.** A luminous element comprising a concave reflecting mirror.

**52.** The luminous element of claim 50 or 51, wherein the luminous element is arranged to be an array and used as a luminous device of an image display apparatus.

**53.** The luminous element of claim 52, wherein the luminous element is used as a luminous device of a projection type image display apparatus.

**54.** The luminous element of claim 52, wherein the luminous element is used as a luminous device of a direct-view type image display apparatus.

**55.** The luminous element of claim 50 or 51, wherein the luminous element is an electro-luminescent element.

**56.** The luminous element of claim 50 or 51, wherein the luminous element is a light emitting diode element.

**57.** The image display apparatus of claim 1, wherein the luminous device is a field emission display, and the parallel-conversion optical system is unnecessary.

**58.** The image display apparatus of claim 57, wherein the field emission display also operates as the optical switch, by means of controlling a phosphor emission based on an electron beam on and off.

**59.** The image display apparatus of claim 1, wherein the optical switch is a digital micro-mirror device composed of arrayed plural mirrors.

**60.** The image display apparatus of claim 1, wherein the luminous device is composed of plural light sources arrayed on a curved surface.

**61.** The image display apparatus of claim 60, wherein the curved surface has its curvature center on an optical axis of beams input into the optical switch.

**62.** The image display apparatus of claim 61, wherein the curved surface is a concave surface.

**63.** The image display apparatus of claim 61, wherein the curved surface is a convex surface.

Fig.1

## Fig.2

## Fig.3

Fig.4

# Fig.5

EP 0 985 952 A1

# Fig.6

# Fig.7

# Fig.8

56

# Fig.9

EP 0 985 952 A1

# Fig.10

# Fig.11

# Fig.12

Fig.13

# Fig.14

(a)

61

51

ON (TRANSPARENT)

f

D

75    95    97    96    95

(b)

51    61    75

OFF (SCATTERING)

95    97

96    95

Fig.15

# Fig.16

57

# Fig.17

57    58    68

# Fig.18

# Fig.19

57  85  74  44

# Fig.20

(a)

47  46  58  45  47

(b)

47  46  58  45  47

# Fig.21

# Fig.22

Fig.23

Fig.24

Fig.25

# Fig.26

# Fig.27

Fig.28

Fig.29

# Fig.30

Fig.31

# Fig.32

| LAMP | METAL HALIDE | XENON | HALOGEN |
|---|---|---|---|
| LUMINOUS EFFICIENCY | 80 lm/W | 30 lm/W | 30 lm/W |
| COLOR TEMPERATURE | 9000 K | 6500 K | 3000 K |
| LIFE TIME | 2000 H | 500 H | 100 H |

Fig.33

# Fig.34

# Fig.35

BEAM A

BEAM B

PARALLEL BEAM

11

10

OPTICAL PATH A

OPTICAL PATH B

# Fig.36

# Fig.37

# Fig.38

# Fig.39

# Fig.40

# Fig.41

# Fig.42

# Fig.43

EP 0 985 952 A1

# Fig.44

EP 0 985 952 A1

# Fig.45

EP 0 985 952 A1

# Fig.46

65

INCIDENT BEAM

151 : MODIFIED
      CURVE SURFACE LENS

CONVERSION BEAM
UNIFORM LUMINANCE DISTRIBUTION

EP 0 985 952 A1

# Fig.47

(a)

(b)

A

INCLUDED
ENERGY 1

EA

POSITION

B

INCLUDED
ENERGY EB

1

POSITION

# Fig.48

# Fig.49

$$\tan \theta = \frac{X_A - X_B}{L} = \frac{X_A - T(X_A)}{L} = \theta\,(X_A, L)$$

# Fig.50

REFLECTOR

PROJECTION LENS

LAMP

LIQUID CRYSTAL PANEL

151

SCREEN

EP 0 985 952 A1

# Fig.51

PANEL SHAPE

# Fig.52

# Fig.53

| LAMP 150W、<br>USING 1.3" COLOR PANEL | REGULAR LENS | MODIFIED CURVE SURFACE LENS |
|---|---|---|
| TOTAL LUMINOUS FLUX AMOUNT [lm] | 121 | 261 |
| CENTER ILLUMINANCE[Lux] | 410 | 731 |
| CIRCUMFERENTIAL ILLUMINANCE [Lux] | 131 | 438 |
| ILLUMINANCE RATIO OF CENTER TO CIRCUMFERENCE [%] (UNIFORMITY) | 32 | 60 |

# Fig.54

(a)

$20mm(1/e^2)$

40mm

→

(b)

300mm

400mm

# Fig.55

# Fig.56

152  153

FOR ONE
PIXEL

151

# Fig.57

# Fig.58

(a)

(b)

152

54B  54R

54G

152  74  153

54B

54G

54R

UNIFORM LUMINANCE
DISTRIBUTION

96

95

EP 0 985 952 A1

# Fig.59

# Fig.60

509 : PROJECTED
LUMINOUS FLUX

508 : LUMINOUS FLUX
EFFECTIVE RANGE

507 : LIQUID CRYSTAL PANEL

POLARIZATION
DIRECTION

20mm

L3=
6mm

27mm

L4=15mm

# Fig.61

502 : SECOND LENS

505

504 : 1/e² POWER POINT

54 : SEMICONDUCTOR LASER

501 : FIRST LENS

503

506

F

504

W

505 : HALF POWER POINT

505

504

504

W

505

A

A

B=2A

C=80mm

EP 0 985 952 A1

# Fig.62

DESIGN EXAMPLE (UNIT : mm)

| No. | A | B | FIRST LENS | | | | SECOND LENS | |
|---|---|---|---|---|---|---|---|---|
| | | | NARROW ANGLE | | WIDE ANGLE | | NARROW ANGLE | WIDE ANGLE |
| | | | HALF(L1) | $1/e^2$ | HALF(L2) | $1/e^2$ | HALF(L3) | HALF(L4) |
| 1 | 9 | 18 | 1.333 | 2.26 | 3.371 | 5.733 | 6 | 15 |
| 2 | 23 | 46 | 3.41 | 5.79 | 8.8 | 15 | | |

EP 0 985 952 A1

## Fig.63

501 : FIRST LENS

508 : LUMINOUS FLUX EFFECTIVE RANGE

507 : LIQUID CRYSTAL PANEL

y

x

L3= 6mm

L4=15mm

No.1DESIGN , FIRST LENS ALLOCATION(CIRCLE LENS)

## Fig.64

501 : FIRST LENS

508 : LUMINOUS FLUX EFFECTIVE RANGE

507 : LIQUID CRYSTAL PANEL

y

x

20mm

L3= 6mm

27mm

L4=15mm

No.2 DESIGN , FIRST LENS ALLOCATION
(A PART OF CIRCLE LENS BEING CUT)

# Fig.65

54 : LD

61 : LENS ARRAY

504 : FIRST LENS

Fig.66

# Fig.67

54 : SEMICONDUCTOR
LASER

51 : LUMINOUS DEVICE

501 : FIRST LENS

61 : LENS ARRAY

502 : SECOND
LENS

507 : LIQUID
CRYSTAL PANEL

L4

L4

L2

B

A

C=80

503

120

L4

120

# Fig.68

511 : SUBSTRATE

512 : COOLING
FIN

513 : LD ARRAY

510 : LENS

120

114

# Fig.69

512 : COOLING FIN

513 : LD ARRAY

510 :
DIFFRACTION
GRATING

120

## Fig.70

540 : EL ELEMENT
521 : CATHODE
522 : TOTAL REFLECTING MIRROR
523 : ELECTRON TRANSPORT LAYER
524 : LUMINOUS LAYER
525 : HOLE TRANSPORT LAYER
527 : LINEAR POLARIZATION ELEMENT
526 : TRANSPARENT ELECTRODE (ITO)
528 : GLASS SUBSTRATE

529 : RADIANT BEAM

## Fig.71

540 : EL ELEMENT
521 : CATHODE
522 : TOTAL REFLECTING MIRROR
523 : ELECTRON TRANSPORT LAYER
524 : LUMINOUS LAYER
525 : HOLE TRANSPORT LAYER
526 : TRANSPARENT ELECTRODE (ITO)
527 : LINEAR POLARIZATION ELEMENT
530 : PARTIAL REFLECTING MIRROR
528 : GLASS SUBSTRATE

529 : RADIANT BEAM

## Fig.72

540 : EL ELEMENT

521 : CATHODE

522 : TOTAL REFLECTING MIRROR

523 : ELECTRON TRANSPORT LAYER

524 : LUMINOUS LAYER

525 : HOLE TRANSPORT LAYER

527 : LINEAR POLARIZATION ELEMENT

526 : TRANSPARENT ELECTRODE (ITO)

528 : GLASS SUBSTRATE

529 : RADIANT BEAM

## Fig.73

540 : EL ELEMENT

521 : CATHODE

522 : TOTAL REFLECTING MIRROR

523 : ELECTRON TRANSPORT LAYER

524 : LUMINOUS LAYER

525 : HOLE TRANSPORT LAYER

526 : TRANSPARENT ELECTRODE (ITO)

527 : LINEAR POLARIZATION ELEMENT

530 : PARTIAL REFLECTING MIRROR

528 : GLASS SUBSTRATE

529 : RADIANT BEAM

EP 0 985 952 A1

# Fig.74

540 : EL ELEMENT

521 : CATHODE

522 : TOTAL REFLECTING MIRROR

523 : ELECTRON TRANSPORT LAYER

527 : LINEAR POLARIZATION ELEMENT

524 : LUMINOUS LAYER

525 : HOLE TRANSPORT LAYER

526 : TRANSPARENT ELECTRODE (ITO)

528 : GLASS SUBSTRATE

529 : RADIANT BEAM

84

## Fig.75

EP 0 985 952 A1

# Fig.76

EP 0 985 952 A1

# Fig.77

561 : P CLAD LAYER
563 : N CLAD LAYER
562 : ACTIVE LAYER
522 : TOTAL REFLECTING MIRROR
527 : LINEAR POLARIZATION ELEMENT
530 : PARTIAL REFLECTING MIRROR
521 : CATHODE

P

N

HOLE

ELECTRON

529 : RADIANT BEAM

564 : ANODE

+ ｜ −

# Fig.78

561 : P CLAD LAYER
562 : ACTIVE LAYER
563 : N CLAD LAYER
522 : TOTAL REFLECTING MIRROR
530 : PARTIAL REFLECTING MIRROR
521 : CATHODE
527 : LINEAR POLARIZATION ELEMENT

P

N

HOLE

ELECTRON

529 : RADIANT BEAM

564 : ANODE

+ ｜ −

# Fig.79

EP 0 985 952 A1

570 : FED

564 : ANODE  569:
ELECTRON
BEAM

566 : PHOSPHOR    567 : SPACER

1mm

1mm

568 :
GLASS FOR
AIRTIGHT
VACUUM

1mm

565 : CIRCUIT SUBSTRATE

521 : CATHODE

# Fig.80

EP 0 985 952 A1

# Fig.81

EP 0 985 952 A1

# Fig.82

95

BEAM 2

BEME 1

θ2

θ1

579 : DMD

581 : MIRROR

# Fig.83

θ1

581

θ2

θ

θ

581

# Fig.84

575:DLP

576

577

91

G

R

95

578

B

53

63

83

# Fig. 85

95 : PROJECTION LENS

575 : DLP

579 : DMD

117 : CONVEX LENS

116 : CONVEX LENS

580 : COLOR FILTER

51

61

B

R

G

EP 0 985 952 A1

## INTERNATIONAL SEARCH REPORT

| | International application No. |
|---|---|
| | PCT/JP99/01439 |

| A. CLASSIFICATION OF SUBJECT MATTER |
|---|
| Int.Cl⁶ G02F1/1335, G02B27/02, 27/18, H01L33/00, H01S3/18, H05B33/00 |

According to International Patent Classification (IPC) or to both national classification and IPC

| B. FIELDS SEARCHED |
|---|
| Minimum documentation searched (classification system followed by classification symbols) |
| Int.Cl⁶ G02F1/1335, G02B27/02, 27/18, H01L33/00, H01S3/18, H05B33/00, G09F9/00-9/46, G09G3/00-3/30 |

Documentation searched other than minimum documentation to the extent that such documents are included in the fields searched
Jitsuyo Shinan Koho       1980-1999
Kokai Jitsuyo Shinan Koho  1980-1999

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP, 7-36040, A (Sharp Corp.),<br>7 February, 1995 (07. 02. 95)<br>& GB, 2278480, A & EP, 627861, A1<br>& US, 5666226, A | 1-7, 12,<br>15-19, 21-24,<br>27-30, 33,<br>36-40, 44-49,<br>58-63 |
| Y | | 8-11, 20,<br>52-55 |
| A | JP, 5-53101, A (Sharp Corp.),<br>5 March, 1993 (05. 03. 93) (Family: none) | 2-7 |
| A | JP, 63-85525, A (Seiko Instruments Inc.),<br>16 April, 1988 (16. 04. 88) (Family: none) | 1-7, 12,<br>15-19, 21-24,<br>27-30, 33,<br>36-40, 44-49,<br>58-63 |
| Y | | 8-11, 20,<br>52-55 |
| X | | 34, 3541-43,<br>56 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search<br>8 June, 1999 (08. 06. 99) | Date of mailing of the international search report<br>22 June, 1999 (22. 06. 99) |
|---|---|
| Name and mailing address of the ISA/<br>Japanese Patent Office | Authorized officer |
| Facsimile No. | Telephone No. |

Form PCT/ISA/210 (second sheet) (July 1992)

## INTERNATIONAL SEARCH REPORT

| | International application No. |
|---|---|
| | PCT/JP99/01439 |

C (Continuation).   DOCUMENTS CONSIDERED TO BE RELEVANT

| Category* | Citation of document, with indication, where appropriate, of the relevant passages | Relevant to claim No. |
|---|---|---|
| X | JP, 3-241311, A  (Seiko Epson Corp.), | 50, 51 |
| Y | 28 October, 1991 (28. 10. 91)  (Family: none) | 52-55 |

Form PCT/ISA/210 (continuation of second sheet) (July 1992)

## INTERNATIONAL SEARCH REPORT

International application No.

PCT/JP99/01439

| Box I Observations where certain claims were found unsearchable (Continuation of item 1 of first sheet) |
|---|

This international search report has not been established in respect of certain claims under Article 17(2)(a) for the following reasons:

1. ☐ Claims Nos.:

because they relate to subject matter not required to be searched by this Authority, namely:

2. ☒ Claims Nos.: 25, 26, 31, 32, 46, 57, 58

because they relate to parts of the international application that do not comply with the prescribed requirements to such an extent that no meaningful international search can be carried out, specifically:
In claim 21, the light source is described as "a light source emitting light by superradiance", and in contrast in claims 25, 26 referring to claim 21, the light source is described as "an electroluminescence device" and "a light-emitting diode device". Therefore what the light source is cannot

3. ☐ Claims Nos.:

because they are dependent claims and are not drafted in accordance with the second and third sentences of Rule 6.4(a).

| Box II Observations where unity of invention is lacking (Continuation of item 2 of first sheet) |
|---|

This International Searching Authority found multiple inventions in this international application, as follows:
The matter common to claims 1 to 63 is to include a light-emitting device or a light source, and it is clear that the light-emitting device itself is not novel.
As a result, the light-emitting device or the light source is within the scope of prior art, and therefore the common matter is not conceived to be a special technical feature according to the second sentence of Article 13(2).
Therefore, there is no matter common to all the claims.
The inventions including technical features considered to be common are four groups of inventions of claims 1 to 21, 22 to 33, 34 to 49, 50 to 63.

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** ☐ The additional search fees were accompanied by the applicant's protest.

☒ No protest accompanied the payment of additional search fees.

Form PCT/ISA/210 (continuation of first sheet (1)) (July 1992)

**INTERNATIONAL SEARCH REPORT**

| International application No. |
| --- |
| PCT/JP99/01439 |

Continuation of Box No. I of continuation of first sheet (1)

be grasped. Claims 31, 32 are also the same in relation to claim 27. In claim 46, superposed light beams are transformed into a parallel beam by means of a single lense, but it is unclear how the beam is transformed into a parallel beam because the superposed portions are different from each other in the positions of the light source. In Figures 66, 67 corresponding to claim 21, the light beams are not superposed on one another when incident on the lens. In claim 1, the light source is described as "a semiconductor laser", and in contrast in claims 57, 58 referring to claim 1, the light source is "a field-emission display". Therefore what the light source is cannot be grasped.

Form PCT/ISA/210 (extra sheet) (July 1992)